(19) Europäisches Patentamt

European Patent Office

Office européen des brevets

(11) **EP 1 155 497 B1**

(12) **FASCICULE DE BREVET EUROPEEN**

(45) Date de publication et mention
de la délivrance du brevet:
**14.08.2002 Bulletin 2002/33**

(51) Int Cl.⁷: **H03H 21/00**

(86) Numéro de dépôt international:
**PCT/FR00/00491**

(21) Numéro de dépôt: **00907739.7**

(22) Date de dépôt: **28.02.2000**

(87) Numéro de publication internationale:
**WO 00/51234 (31.08.2000 Gazette 2000/35)**

(54) **PROCEDE ET SYSTEME DE TRAITEMENT DE SIGNAUX D'ANTENNE**

SYSTEM UND VERFAHREN ZUM VERARBEITEN VON ANTENNENSIGNALEN

ANTENNA TREATMENT METHOD AND SYSTEM

(84) Etats contractants désignés:
**DE GB IT**

(30) Priorité: **26.02.1999 FR 9902662**

(43) Date de publication de la demande:
**21.11.2001 Bulletin 2001/47**

(73) Titulaire: **FRANCE TELECOM exploitant public**
**75015 Paris (FR)**

(72) Inventeurs:
• **MARRO, Claude**
**F-22220 Plouguiel (FR)**
• **TAGER, Wolfgand**
**D-81673 Munich (DE)**

(74) Mandataire: **Maillet, Alain**
**SCP Le Guen & Maillet,**
**5, Place Newquay,**
**B.P. 70250**
**35802 Dinard Cedex (FR)**

(56) Documents cités:
• SIMMER K U ET AL: "ANALYSIS AND COMPARISON OF SYSTEMS FOR ADAPTIVE ARRAY PROCESSING OF SPEECH SIGNALS IN A NOISY ENVIRONMENT" COLLOQUE SUR LE TRAITEMENT DU SIGNAL ET DES IMAGES,FR,NICE, GRETSI, vol. COLLOQUE 13, page 529-532 XP000242829
• ZELINSKI R: "NOISE REDUCTION BASED ON MICROPHONE ARRAY WITH LMS ADAPTIVE POST-FILTERING" ELECTRONICS LETTERS,GB,IEE STEVENAGE, vol. 26, no. 24, novembre 1990 (1990-11), page 2036-2037 XP000175631 ISSN: 0013-5194

**Description**

La présente invention telle que définie dans les revendication concerne des procédés et des systèmes d'antenne, notamment pour l'amélioration du rapport de la puissance du signal utile à celle des signaux perturbateurs.

Dans la présente description, le terme antenne est pris au sens large. En effet, on considérera qu'une antenne est un dispositif servant à émettre ou recevoir des ondes transportant de l'information. L'objectif principal d'une antenne est donc d'extraire l'information utile en discriminant les signaux perturbateurs qui sont dus à du bruit, des sources perturbatrices, des réflexions, etc.

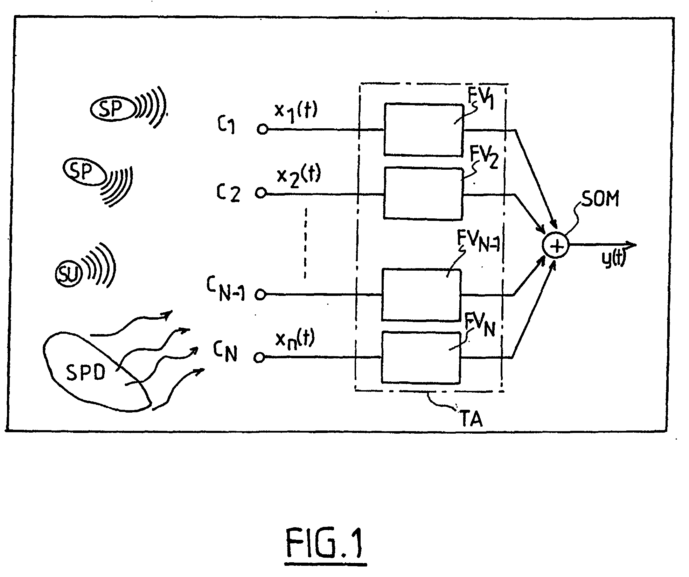

La présente invention n'est concernée que par les antennes réceptrices composées d'éléments discrets. Une telle antenne est représentée à la Fig. 1. Elle est constituée de $N$ capteurs $C_1$ à $C_N$ destinés à capter des signaux issus de diverses sources, telles qu'au moins une source utile SU, des sources perturbatrices SP et d'autres sources de perturbations SPD à caractères plus diffus. Chaque capteur $C_i$ ($i = 1,..., N$) délivre un signal perturbé $x_i(t)$ variant avec le temps $t$ qui est ensuite filtré par un filtre de voie $FV_i$ de fonction de transfert $a_i(t)$ ($i = 1,..., N$) dont le rôle est de contrôler plusieurs aspects de l'antenne. L'ensemble de ces filtres assure une directivité donnée à l'antenne (par exemple l'ouverture du lobe principal et/ou la remontée des lobes secondaires, la réjection dans des directions non-désirées, etc.). Il permet également le pointage de l'antenne dans la direction de la source utile SU.

Les sorties de ces filtres $FV_i$ sont reliées aux entrées correspondantes d'un sommateur SOM qui délivre alors le signal de sortie de l'antenne $y(t)$.

On connaît une multitude de réalisations des filtres de voie et de leur mise en oeuvre. La réalisation de ces filtres dépend notamment du positionnement géométrique des capteurs et de la nature des signaux à traiter. Ces filtres peuvent avoir des caractéristiques définies une fois pour toutes (ce qui est le cas des antennes fixes) ou au contraire des caractéristiques qui varient au cours du temps (ce qui est le cas des antennes adaptatives). Pour ces dernières, les algorithmes qui adaptent les coefficients des filtres au cours du temps font généralement intervenir un dispositif de contrôle qui est propre à l'application considérée. Par exemple, il peut s'agir d'un prélèvement du signal perturbateur aux instants où la source utile SU est inactive. Un tel dispositif de contrôle n'est pas représenté à la Fig. 1 pour des raisons de clarté.

Le procédé de la présente invention est appliqué à des antennes indépendamment du traitement appliqué au signal $x_i(t)$ issu de chaque capteur $C_i$ (filtrage de voie fixe, formation de voie adaptative, etc.). Il convient alors de faire abstraction du traitement de signal réalisé entre l'acquisition des signaux $x_i(t)$ et la sortie d'antenne et de considérer l'élément TA comme une "boîte noire" mettant en oeuvre un traitement dit traitement d'antenne dans la suite de la description.

Dans la présente description, le terme "traitement d'antenne" désigne par conséquent l'ensemble des traitements d'antenne, notamment ceux qui sont connus aujourd'hui.

Selon le domaine d'application, les antennes peuvent présenter des performances limitées. Notamment, la réduction des perturbations issues par exemple des sources de perturbations SP ou SPD peut s'avérer insuffisante. Généralement, ces performances sont mesurées au moyen d'une grandeur qui est un élément caractéristique de l'efficacité d'une antenne et qui est appelée gain en rapport signal sur bruit de l'antenne. Par le terme "bruit", on désigne l'ensemble des signaux perturbateurs que l'antenne est destinée à réduire et le rapport signal sur bruit est alors le rapport de la puissance du signal utile à celle des signaux perturbateurs.

Le procédé de la présente invention est applicable à tous les domaines où une antenne est, ou pourrait être, utilisée. Une liste de domaines non exhaustive est donnée ci-dessous :

    1) Prise de son par antennes acoustiques telle que :

-    Prise de son pour les stations de travail (PC multimédia, etc..),
-    Prise de son mains-litres dans les véhicules,
-    Prise de son dans les lieux publiques (gare, aéroport, etc..),
-    Prise de son pour la téléconférence et la visioconférence,
-    Prise de son mains-libres pour la téléphonie,
-    Prise de son pour le cinéma et les médias (radio, télévision, par exemple pour le journalisme sportif ou les concerts, etc..),

    2) Réception par antenne pour les ondes radioélectriques (radiocommunications, télédétection, etc.),
    3) Réception par antenne sonar (imagerie sous-marine, télédétection, etc.).
    4) Traitement multi-capteur appliqué aux signaux biomédicaux (EEG, ECG, imagerie biomédicale etc..).

Le but de la présente invention est de réduire les composantes du signal nuisible non supprimées par l'antenne, et par conséquent à améliorer le rapport de la puissance du signal utile à celle des signaux perturbateurs de celle-ci.

Parmi les techniques de l'état de l'art portant sur l'utilisation d'un traitement appliqué en sortie d'antenne, encore appelé post-traitement, on connaît celles qui sont relatives aux systèmes de prise de son multi-capteurs. Dans la présente description, on se limitera à décrire ces techniques, mais pour les expliquer convenablement, on décrira leur détail algorithmique général dans le cadre d'une application de type prise de son pour le signal de parole utilisé pour les stations multimédia (PC communicants, etc..) qui est le contexte visé par les auteurs des communications référencées.

La combinaison d'un réseau de microphones et d'un post-traitement a été décrite pour la première fois par J.B. Allen en 1977 dans un article paru dans *J. Acoust. Soc. Am.,* vol. 62, N° 4, pp. 912-915, 1977 et intitulé "Multimicrophone signal processing technique to remove reverberation from speech signals". Elle avait pour but d'éliminer les signaux de réverbération émis lors de la prise de son éloignée en milieu réverbérant. Dans cet article, est décrite une prise de son réalisée par deux microphones et un traitement complet basé sur la fonction de cohérence et réalisé dans le domaine fréquentiel.

En 1988, R. Zelinski décrit, dans un article paru dans *Proc. ICASSP-88*, pp. 2578-2581, New York, USA, 1988 et intitulé "A microphone array with adaptive post-filtering for noise reduction in reverberant rooms", étend cette technique à une prise de son mettant en jeu un nombre supérieur de capteurs. En 1992, K.U. Simmer, dans un article paru dans *Proc. ISSSE-92*, Paris, France, September 1992 et intitulé "Time delay compensation for adaptive multichannel speech enhancement systems", propose une expression de la fonction de transfert du post-traitement selon une approche du type "filtrage de Wiener".

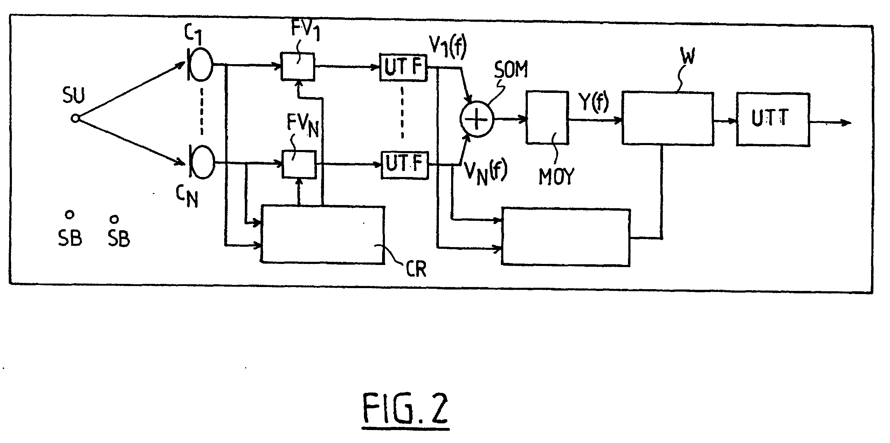

L'analyse qui suit permet de décrire l'ensemble de ces méthodes et, ce, en relation avec la Fig. 2.

Dans ce système d'antenne, les signaux de parole perturbés $x_i(n)$ sont captés par une antenne composée de $N$ microphones $C_1$ à $C_N$ et leur expression est donnée sous la relation générale :

$$x_i(n)=s(n\text{-}\tau_{hi})+n_i(n), \qquad i=1,...,N \tag{1}$$

où $s$ désigne le signal de parole issu de la source SU et $n_i$ le signal de bruit issu des sources SB et reçu par le capteur $C_i$. Du fait du formalisme orienté "traitement numérique du signal", $n$ représente l'indice temporel en temps discret. $\tau_{hi}$ est le retard introduit par la propagation du signal émis entre la source SU et le capteur $C_i$. Pour réaliser la remise en phase de chaque signal $x_i(n)$, c'est-à-dire pour réaliser le pointage de l'antenne dans la direction de la source SU, l'antenne est pointée dans la direction du locuteur désiré à l'aide du filtre de voie $FV_i$ de fonction de transfert $r_i(n)$ et délivrant un signal $v_i(n)$ donné par l'expression suivante :

$$v_i(n)=r_i(n)*x_i(n), \qquad i=1,..., N \tag{2}$$

où * désigne le produit de convolution.

Les signaux délivrés par les filtres de voie $FV_1$ à $FV_N$ font l'objet d'une transformée dans le domaine fréquentiel pour permettre leur traitement ultérieur dans le domaine fréquentiel. A l'issue de cette transformation, ces signaux sont les signaux notés $V_1(f)$ à $V_N(f)$ qui sont alors sommés dans le sommateur SOM et moyennés dans le moyenneur MOY. Le signal $Y(f)$ issu du moyenneur MOY est l'objet, dans le filtre W, d'un filtrage dans le domaine fréquentiel de fonction de transfert $W(f)$.

Le filtre optimal W, au sens de l'erreur quadratique moyenne, de fonction transfert $\hat{W}_{opt}(f)$ est obtenu en minimisant l'erreur quadratique moyenne entre le signal désiré $s$ et un signal estimé $\hat{s}$. D'après l'équation de Wiener-Hopf et sous la seule hypothèse de remise en phase parfaite du signal utile $s(n)$, l'expression générale du filtre de Wiener s'écrit dans le domaine fréquentiel :

$$W_{opt}(f)=\frac{\Phi_{ys}(f)}{\Phi_{yy}(f)} \tag{3}$$

où $\Phi_{yy}(f)$ est la densité spectrale de puissance du signal $y(n)$ en sortie du moyenneur MOY et $\Phi_{ys}(f)$ est la densité interspectrale de puissance des signaux $y(n)$ et $s(n)$.

Cette expression du filtre optimal s'écrit à partir du signal utile $s(n)$ et du bruit moyen en sortie de formation de voie $\bar{n}$ en supposant que le signal $x_i(n)$ parvenant à chaque capteur $C_i$ est modélisé par la somme du signal utile $s(n)$ et du bruit $n_i(n)$, que $_{\text{chacun}}$ des bruits $n_i(n)$ et le signal utile $s(n)$ sont décorrélés, que les densités spectrales de puissance des bruits $n_i(n)$ sont identiques sur chaque microphone ($\Phi_{n_i n_i}(f)=\Phi_{nn}(f)$, $\forall\, i = 1,..., N$), que les bruits $n_i(n)$

sont décorrélés entre capteurs ($\Phi_{n_i n_j}(f)=0$, $i \neq$ j) et qu'enfin, les signaux d'entrée $x_i(n)$ sont parfaitement remis en phase vis-à-vis du signal utile *s(n)*.

L'expression de la fonction de transfert du filtre ainsi obtenue est la suivante :

$$W_{opt}(f) = \frac{\Phi_{ss}(f)}{\Phi_{ss}(f) + \Phi_{\overline{nn}}(f)} \tag{4}$$

où $\Phi_{ss}(f)$ et $\Phi_{\overline{nn}}(f)$ sont les densités spectrales de puissance du signal utile *s(n)* et du bruit *n(n)* en sortie de formation de voie.

Ces deux dernières grandeurs $\Phi_{ss}(f)$ et $\Phi_{\overline{nn}}(f)$, nécessaires au calcul de $W_{opt}(f)$, sont *a priori* inconnues et posent donc un problème pour leur estimation. Pour l'ensemble des méthodes exposées dans l'état de la technique, $\Phi_{ss}(f)$ et $\Phi_{\overline{nn}}(f)$ sont estimées à partir des signaux reçus sur les différents capteurs. Par exemple sous l'hypothèse de non-corrélation des bruits sur chaque microphone, l'estimation de la densité spectrale $\Phi_{ss}(f)$ du signal utile peut être réalisée à partir des densités interspectrales de puissance $\Phi_{v_i v_j}(f)$ des signaux $x_i(n)$ et $x_j(n)$ issus des capteurs $C_i$ et $C_j$ remis en phase au moyen des filtres $FV_i$ et du compensateur de retard CR. Ce sont les estimateurs des densités spectrales et interspectrales de puissance qui distinguent les différents procédés de l'art antérieur.

En considérant les hypothèses sur les signaux d'entrée posées précédemment, les grandeurs spectrales $\Phi_{v_i v_i}(f)$ et $\Phi_{v_i v_j}(f)$ peuvent s'écrire:

$$\Phi_{v_i v_i}(f) = \Phi_{ss}(f) + \Phi_{nn}(f) \tag{5}$$

$$\Phi_{vivj}(f) = \Phi_{ss}(f), \qquad i \neq j \tag{6}$$

Un moyen d'estimer $W_{opt}(f)$ consiste à utiliser une moyenne de ces densités spectrales et interspectrales de puissance respectivement au dénominateur et au numérateur :

$$\hat{W}(f) = \frac{\dfrac{2}{N(N-1)} \gamma \left( \displaystyle\sum_{i=1}^{N-1} \sum_{j=i+1}^{N} \hat{\Phi}_{v_i v_j}(f) \right)}{\dfrac{1}{N} \displaystyle\sum_{i=1}^{N} \hat{\Phi}_{v_i v_i}(f)} \quad \text{avec } \gamma(.) = Re(.) \text{ ou } \gamma(.) = |.| \tag{7}$$

L'utilisation de l'opérateur module ou partie réelle $\gamma(.)$ est justifiée par la grandeur à estimer au numérateur, $\Phi_{ss}(f)$, qui doit être réelle et positive. La notation "^" désigne l'estimation (au sens statistique) de la grandeur sur laquelle elle s'applique.

L'estimateur $\hat{W}(f)|_{\gamma(.)=Re(.)}$ a été proposé par R. Zelinski [voir l'article mentionné précédemment] avec une mise en oeuvre dans le domaine temporel. Dans l'article de Simmer de 1992, l'estimation et le filtrage sont réalisés dans le domaine fréquentiel. $\hat{W}(f)|_{\gamma(.)=|.|}$ est alors une extension à un nombre quelconque de capteurs du traitement bicapteurs décrit par Allen en 1977. En fait, l'équation (7) précédente représente, d'un point de vue du principe algorithmique, deux méthodes d'estimation du filtre de Wiener: $\hat{W}(f)|_{\gamma(.)=Re(.)}$ et $\hat{W}(f)|_{\gamma(.)=|.|}$.

Sur la Fig. 2, on notera que les grandeurs spectrales nécessaires à l'estimation du filtre W, c'est-à-dire les densités $\Phi_{v_i v_i}(f)$ et $\Phi_{v_i v_j}(f)$ sont elles-mêmes à estimer à partir des signaux issus des capteurs $C_1$ à $C_N$ et traités par les filtres de voie $FV_1$ à $FV_N$. En effet, en pratique, la mise en oeuvre d'un postfiltre en considérant un environnement réel et des signaux de parole nécessite une estimation qui assure le suivi de la non-stationnarité de tels signaux tout en garantissant une qualité d'estimation acceptable.

Un des inconvénients des procédés de l'art antérieur réside dans le fait que l'implémentation de ces post-traitements nécessite l'estimation d'un nombre important de grandeurs spectrales. Il faut estimer $N(N - 1)/2$ densités interspectrales de puissance pour le calcul du numérateur de la fonction $\hat{W}(f)$ et $N$ densités spectrales de puissance pour le calcul de son dénominateur, d'où un total de $N(N + 1)/2$ grandeurs spectrales. Dans le cas d'une antenne composée de 9 microphones, 45 grandeurs spectrales doivent ainsi calculées : 36 densités interspectrales de puissance et 9 densités spectrales de puissance.

L'estimation de la densité spectrale de puissance $\Phi_{ss}(f)$ du signal utile *s(t)* est réalisée par la moyenne des densités interspectrales de puissance des signaux microphoniques remis en phases. En présence de perturbations, il faudrait que celles-ci respectent l'hypothèse selon laquelle les perturbations sont décorrélées entre capteurs pour que cette fonction $\Phi_{ss}(f)$ soit correctement estimée. Or, dans la réalité, les sources de bruit localisé ainsi que certaines réflexions sont des signaux cohérents d'un capteur à l'autre. De ce fait, ces sources nuisibles ne pourront pas être discriminées par l'opération $\Phi_{v_i v_j}(f)$ et l'estimation de $\Phi_{ss}(f)$ s'en trouvera biaisée (équation 6 ci-dessus non respectée). Ce biais sera d'autant plus important que le rapport signal à bruit est faible. Le biais rajouté à la fonction $\Phi_{ss}(f)$ est la composante cohérente de la densité interspectrale de puissance du bruit, qui sera d'autant plus importante que le niveau de bruit est élevé. Ceci aura deux conséquences : une diminution des performances en termes de réduction des perturbations et une dégradation du signal utile. Il s'ensuit que le système complet (antenne + postfiltrage) peut être moins performant que l'antenne seule.

En plus du biais sur l'estimation de la fonction $\Phi_{ss}(f)$ qu'occasionnent les caractéristiques réelles des perturbations, celles-ci entraînent également une limitation des performances du système même en absence de signal utile. Aux instants où le signal utile $s(n)$ est inactif, le post-traitement $W(f)$ devrait en théorie complètement supprimer le bruit, du fait que les densités interspectrales de puissance $\Phi_{v_i v_j}(f)$, qui sont dans ce cas les densités interspectrales de puissance des seuls bruits, devraient être nulles. Dans la réalité, on n'obtient pas ce résultat une fois encore parce que la nature statistique des perturbations font que la précédente hypothèse n'est pas respectée. Les sources perturbatrices localisées ainsi que certaines réflexions ne seront pas suffisamment réduites.

Le but de la présente invention est de proposer un procédé d'antenne qui permette de résoudre les problèmes engendrés par les procédés de l'art antérieur.

A cet effet, un procédé d'amélioration du rapport signal utile à signaux perturbateurs d'une antenne est caractérisé en ce qu'il consiste à filtrer le signal délivré par ladite antenne au moyen d'un filtre dont la fonction de transfert est égale au rapport de deux fonctions linéaires de la puissance du signal à la sortie de l'antenne et de la puissance du ou des signaux respectivement délivrés par le ou les capteurs à l'entrée de ladite antenne.

Avantageusement, ladite fonction de transfert est égale au rapport de la puissance du signal à la sortie de l'antenne et de la puissance du ou des signaux respectivement délivrés par le ou les capteurs à l'entrée de ladite antenne.

Selon une autre caractéristique de l'invention, il consiste à estimer la puissance du signal à la sortie de l'antenne et la puissance du ou des signaux respectivement délivrés par le ou les capteurs à l'entrée de l'antenne.

Pour ce faire, dans une première variante, il consiste à utiliser, pour pourvoir estimer la puissance du ou des signaux respectivement délivrés par le ou les capteurs à l'entrée de l'antenne, le, des ou les signaux respectivement délivrés par le, des ou les capteurs de ladite antenne.

Selon une autre variante, il consiste à utiliser, pour pourvoir estimer la puissance du ou des signaux respectivement délivrés par le ou les capteurs à l'entrée de l'antenne, le ou des signaux issus du traitement, dans une unité de traitement d'antenne de ladite antenne, des signaux respectivement délivrés par les capteurs de ladite antenne.

La présente invention concerne également un procédé de traitement d'antenne du type qui consiste à transformer dans le domaine fréquentiel le ou chaque signal délivré par au moins capteur, à filtrer le ou chaque signal issu de ladite transformation, à sommer entre eux les signaux respectivement obtenus après filtrage et à transformer dans le domaine temporel le signal obtenu après sommation.

Selon une caractéristique de la présente invention, ledit procédé est caractérisé en ce qu'il consiste en outre à filtrer le signal obtenu après sommation au moyen d'un filtre dont la fonction de transfert est égale au rapport de deux fonctions linéaires de la puissance du signal présent à la sortie du sommateur et de la puissance du ou des signaux délivrés par ladite ou lesdites unités de transformation dans le domaine fréquentiel.

Avantageusement, la fonction de transfert est égale au rapport de la puissance du signal présent à la sortie du sommateur et de la puissance du ou des signaux délivrés par ladite ou lesdites unités de transformation dans le domaine fréquentiel.

Avantageusement, il consiste à estimer la puissance du signal à la sortie de l'antenne et la puissance du ou des signaux respectivement délivrés par le ou les capteurs à l'entrée de l'antenne.

Selon une autre caractéristique de l'invention, il consiste à, pour effectuer l'estimation de la puissance du ou des signaux respectivement délivrés par le ou les capteurs à l'entrée de l'antenne, effectuer la moyenne de l'estimation des densités spectrales de puissance des signaux issus du ou des capteurs.

Selon une autre caractéristique de l'invention, pour effectuer l'estimation de la puissance du signal en sortie du sommateur, il consiste à calculer l'estimation de la densité spectrale de puissance de ce signal.

Selon une autre caractéristique de l'invention, il consiste à effectuer lesdites estimations de manière récursive par lissage à oubli exponentiel.

La présente invention concerne également un système d'antenne qui comprend une antenne pourvue d'au moins un capteur et qui est prévu pour améliorer le rapport de la puissance du signal utile à celle des signaux perturbateurs de ladite antenne. Il est caractérisé en ce qu'il comprend un filtre qui est prévu pour filtrer le signal délivré par ladite antenne et dont la fonction de transfert est égale au rapport de deux fonctions linésires de la puissance du signal présent à la sortie de l'antenne et de la puissance du ou des signaux délivrés par le ou les capteurs à l'entrée de l'antenne.

Avantageusement, ladite fonction de transfert est égale au rapport de la puissance du signal présent à la sortie de l'antenne et de la puissance du ou des signaux délivrés par le ou les capteurs à l'entrée de l'antenne.

Avantageusement, ledit système comporte des unités d'estimations pour pouvoir respectivement estimer la puissance du signal présent à la sortie de l'antenne et la puissance du ou des signaux délivrés par le ou lesdits capteurs à l'entrée de l'antenne.

Ladite unité d'estimation pour pouvoir estimer la puissance à l'entrée de l'antenne, traite le, des ou les signaux respectivement délivrés par un, des ou les capteurs de ladite antenne.

Ladite unité d'estimation pour pouvoir estimer la puissance à l'entrée de l'antenne, traite le ou des signaux délivrés par une unité de traitement d'antenne de ladite antenne à partir des signaux respectivement délivrés par les capteurs de ladite antenne.

Ladite invention concerne encore un système d'antenne du type qui comprend une unité de transformation dans le domaine fréquentiel du ou de chaque signal délivré par au moins capteur, un filtre de voie pour filtrer dans le domaine fréquentiel le signal délivré par ladite unité de transformation, un sommateur pour sommer entre eux les signaux respectivement délivrés par lesdits filtres de voie et une unité de transformation dans le domaine temporel du signal délivré par ledit sommateur.

Il est caractérisé en ce qu'il comporte, entre le sommateur et l'unité de transformation dans le domaine temporel, un filtre dont la fonction de transfert est égale au rapport de deux fonctions linéaires de la puissance du signal présent à la sortie du sommateur et de la puissance du ou des signaux délivrés par ladite unité de transformation dans le domaine fréquentiel. Avantageusement, la fonction de transfert dudit filtre est égale au rapport de la puissance du signal présent à la sortie du sommateur et de la puissance du ou des signaux délivrés par ladite unité de transformation dans le domaine fréquentiel.

Ledit système d'antenne comporte des unités d'estimations pour pouvoir respectivement estimer la puissance du signal présent à la sortie du sommateur et la puissance du ou des signaux délivrés par lesdites unités de transformation dans le domaine fréquentiel.

Ladite unité d'estimation pour l'estimation de la puissance du ou des signaux respectivement délivrés par le ou les capteurs à l'entrée de l'antenne effectue la moyenne de l'estimation des densités spectrales de puissance des signaux issus du ou des capteurs.

Ladite unité d'estimation pour l'estimation de la puissance du signal en sortie du sommateur est donnée par l'estimation de la densité spectrale de puissance de ce signal.

Avantageusement, ledit système comporte des moyens pour que lesdites estimations soient effectuées de manière récursive par lissage à oubli exponentiel.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

La Fig. 1 est un schéma synoptique d'une antenne au sens de la présente description,
La Fig. 2 est un schéma synoptique d'un système d'antenne équipé d'un post-filtre selon l'état de la technique,
La Fig. 3 est un schéma synoptique d'un premier mode de réalisation d'un système d'antenne équipé d'un post-filtre selon la présente invention,
La Fig. 4 est un schéma synoptique d'un second mode de réalisation d'un système d'antenne équipé d'un post-filtre selon la présente invention,
La Fig. 5 est un schéma synoptique d'un troisième mode de réalisation d'un système d'antenne équipé d'un post-filtre selon la présente invention,
La Fig. 6 est un graphe montrant, en fonction du temps, les amplitudes des signaux utile et perturbateur en sortie d'une antenne non équipée d'un post-filtre selon l'invention,
La Fig. 7 est un graphe montrant, en fonction du temps, les amplitudes des signaux utile et perturbateur en sortie d'un post-filtre mis en oeuvre selon l'invention, et
La Fig. 8 est un graphe montrant, en fonction du temps, les niveaux des signaux perturbateurs en entrée d'antenne, en sortie d'antenne et sortie de post-filtre.

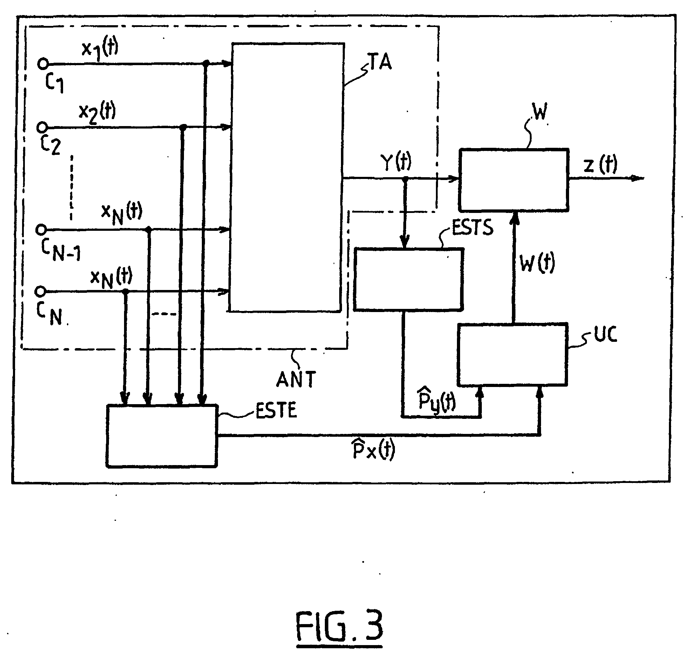

On a représenté à la Fig. 3 un schéma synoptique d'un système d'antenne prévu pour mettre en oeuvre le procédé de la présente invention. Ce système est constitué d'une antenne ANT elle-même constituée d'une pluralité de capteurs $C_1$ à $C_N$ dont les signaux de sortie $x_1(t)$ à $x_N(t)$ sont fournis à une unité de traitement d'antenne TA prévue pour elle-même délivrer un signal de sortie d'antenne $y(t)$.

Le système représenté comprend une unité de post-filtrage PF prévue pour appliquer au signal $y(t)$ un post-filtrage dont la fonction de transfert est une fonction $W(t)$ qui, selon l'invention, est égale au rapport de deux fonctions

F et G linéaires de la puissance $\hat{P}_y(t)$ à la sortie de l'antenne ANT et de la puissance $\hat{P}_x(t)$ à l'entrée de l'antenne ANT telles qu'elles sont respectivement estimées par des unités d'estimation ESTE et ESTS.

D'une manière générale, ces deux fonctions F et G s'écrivent donc de la manière suivante :

$$F\left(\hat{P}_x(t),\hat{P}_y(t)\right)=\alpha(t).\hat{P}_x(t)+\beta(t).\hat{P}_y(t),\qquad(8)$$

$$G\left(\hat{P}_x(t),\hat{P}_y(t)\right)=\gamma(t).\hat{P}_x(t)+\eta(t).\hat{P}_y(t),\qquad(9)$$

et la fonction de transfert $W(t)$ :

$$W(t)=\frac{F\left(\hat{P}_x(t),\hat{P}_y(t)\right)}{G\left(\hat{P}_x(t),\hat{P}_y(t)\right)}=\frac{\alpha(t).\hat{P}_x(t)+\beta(t).\hat{P}_y(t)}{\gamma(t).\hat{P}_x(t)+\eta(t).\hat{P}_y(t)}\qquad(10)$$

La fonction de transfert $W(t)$ est calculée par une unité UC et est délivrée à l'unité de post-filtrage PF.

On notera que le procédé de la présente invention pourrait être mis oeuvre dans le domaine fréquentiel. La fonction $W(t,f)$ du post-filtre est alors calculée pour chaque composante fréquentielle ou moyen de la relation suivante :

$$W(t,f)=\frac{F\left(\hat{P}_x(t,f),\hat{P}_y(t,f)\right)}{G\left(\hat{P}_x(t,f),\hat{P}_y(t,f)\right)}\qquad(11)$$

où $\hat{P}_x(t,f)$ et $\hat{P}_y(t,f)$ sont respectivement les représentations dans le domaine fréquentiel de la puissance en entrée $P_x(t)$ et de la puissance en sortie $P_y(t)$ et $W(t,f)$ la représentation dans le domaine fréquentiel du post-filtre $W(t)$.

Dans la suite de la description, on considérera les fonctions

$$F\left(\hat{P}_x(t),\hat{P}_y(t)\right)$$

et

$$G\left(\hat{P}_x(t),\hat{P}_y(t)\right)$$

comme étant respectivement égales à la puissance en sortie $\hat{P}_y(t)$ et à la puissance en entrée $\hat{P}_x(t)$, soit :

$$F\left(\hat{P}_x(t),\hat{P}_y(t)\right)=\hat{P}_y(t)\qquad(12)$$

et

$$G\left(\hat{P}_x(t),\hat{P}_y(t)\right)=\hat{P}_x(t)\qquad(13)$$

Le post-filtrage PF ainsi réalisé consiste à appliquer au signal $y(t)$ une fonction de transfert $W(t)$ qui, selon l'invention, est égale au rapport de la puissance $\hat{P}_y(t)$ à la sortie de l'antenne ANT et de la puissance $\hat{P}_x(t)$ à l'entrée de l'antenne ANT telles qu'elles sont respectivement estimées par des unités d'estimation ESTE et ESTS :

$$W(t)=\frac{\hat{P}_y(t)}{\hat{P}_x(t)} \qquad (14)$$

Pour une mise en oeuvre dans le domaine fréquentiel, la fonction $W(t,f)$ du post-filtre est alors calculée au moyen de la relation suivante :

$$W(t,f)=\frac{\hat{P}_y(t,f)}{\hat{P}_x(t,f)} \qquad (15)$$

où $\hat{P}_x(t,f)$ et $\hat{P}_y(t,f)$, comme mentionné précédemment, sont respectivement les représentations dans le domaine fréquentiel de la puissance en entrée $P_x(t)$ et de la puissance en sortie $P_y(t)$ et $W(t,f)$ la représentation dans le domaine fréquentiel du post-filtre $W(t)$.

On notera que, dans ce formalisme, une grandeur $A(t,f)$ dans le domaine fréquentiel représente la même grandeur $a(t)$ dans le domaine temporel à l'instant $t$ et pour la fréquence $f$. On sait que le passage d'un signal du domaine temporel au domaine fréquentiel nécessite une durée d'observation. En conséquence, la grandeur $A(t,f)$ a une valeur connue à l'instant $t$, mais son calcul a pu nécessiter une durée dont la valeur est propre au domaine d'application où le procédé objet de l'invention serait appliqué.

L'estimation de la puissance du signal en sortie d'antenne, $\hat{P}_y(t)$, peut être réalisée de manières très variées qui dépendent du domaine d'application auquel le procédé objet du brevet pourrait être utilisé. La lettre $t$ désignant le temps, l'estimation de la puissance de sortie d'antenne $P_y(t)$ est une valeur de puissance instantanée qui varie donc au cours du temps et qui est estimée en permanence à partir du signal $y(t)$. Selon l'application envisagée, on accordera un temps d'intégration plus ou moins important selon les caractéristiques de stationnarité des signaux utilisés.

On notera que la variable temps peut être discrète ou continue.

La description faite ci-dessus pour l'estimation de puissance en sortie d'antenne $\hat{P}_y(t)$ (ou $\hat{P}_y(t,f)$) s'applique également à l'estimation de puissance à l'entrée de l'antenn $P_x(t)$ (ou $P_x(t,f)$). La différence avec l'estimation de puissance de sortie $P_y(t)$ (ou $P_y(t,f)$) réside sur l'aspect multi-capteur de l'entrée d'antenne. En effet, un seul capteur, seulement quelques capteurs, ou tous les capteurs (cas représenté) peuvent être utilisés pour estimer la puissance d'entrée de l'antenne $P_x(t)$ (ou $P_x(t,f)$).

D'un point de vue algorithmique, le post-filtrage est obtenu conformément à l'une des deux dernières équations à partir des estimations de puissance d'entrée et de sortie d'antenne, $P_x(t)$ et $P_y(t)$ dans le domaine temporel, ou $P_x(t,f)$ et $P_y(t,f)$ dans le domaine fréquentiel. De ce fait, le post-filtrage varie au cours du temps au même rythme que les estimations des puissances $P_x(t)$ et $P_y(t)$ ou $P_x(t,f)$ et $P_y(t,f)$. Ainsi. la fonction du postfiltre résultant peut être seulement temporel $W(t)$ (c'est-à-dire un gain global variant au cours du temps) ou avoir en plus une représentation fréquentielle $W(t,f)$ (c'est-à-dire un gain pour chaque composante fréquentielle, dont chacune varie au cours du temps). Le post-filtrage peut être appliqué en l'état, mais on peut également lui appliquer des transformations linéaires ou non-linéaires, telles des limitations d'amplitude dans un intervalle de valeurs prédéterminées pour éviter des valeurs aberrantes dues à d'éventuelles erreurs dans la détermination des estimations $P_x(t)$ et $P_y(t)$ ou $P_x(t,f)$ et $P_y(t,f)$, des fonctions de pondération, etc.

Dans le domaine temporel, l'opération de postfiltrage est une opération de convolution. L'expression du signal de sortie $z(t)$ du système d'antenne de l'invention peut donc alors s'écrire sous la forme :

$$z(t)=y(t)*W(t) \qquad (16)$$

où * désigne le produit de convolution.

Dans le domaine fréquentiel, cette opération est une simple multiplication. L'expression du signal $z(t,f)$ en sortie du post-filtre W dans le domaine fréquentiel peut donc alors s'écrire :

$$z(t,f)=y(t,f)W(t,f) \qquad (17)$$

Cette opération de filtrage peut être réalisée par diverses méthodes, et ceci compte tenu du domaine d'application et du traitement de l'antenne sur lequel on souhaite appliquer le procédé objet de l'invention (i.e. temporelle, fréquentielle, analogique, numérique, etc..). Cette étape permet d'obtenir le signal en sortie de traitement $z(t)$ (avec retour préalable dans le domaine temporel de $z(f)$ dans le cadre de la mise en oeuvre dans le domaine fréquentiel).

On notera qu'il peut être intéressant d'utiliser des signaux générés au sein même du dispositif de traitement d'antenne TA pour estimer la puissance d'entrée. Par exemple, cela peut être le cas pour des antennes où certains capteurs sont alloués à une bande de fréquence (dans ce cas, un filtrage est réalisé à l'intérieur même du traitement d'antenne pour chacun de ces capteurs). Si l'on ne désire appliquer le post-filtrage, qu'à cette bande de fréquence, on peut utiliser les seuls signaux en sortie des filtres implémentés dans le traitement d'antenne TA pour faire cette détermination.

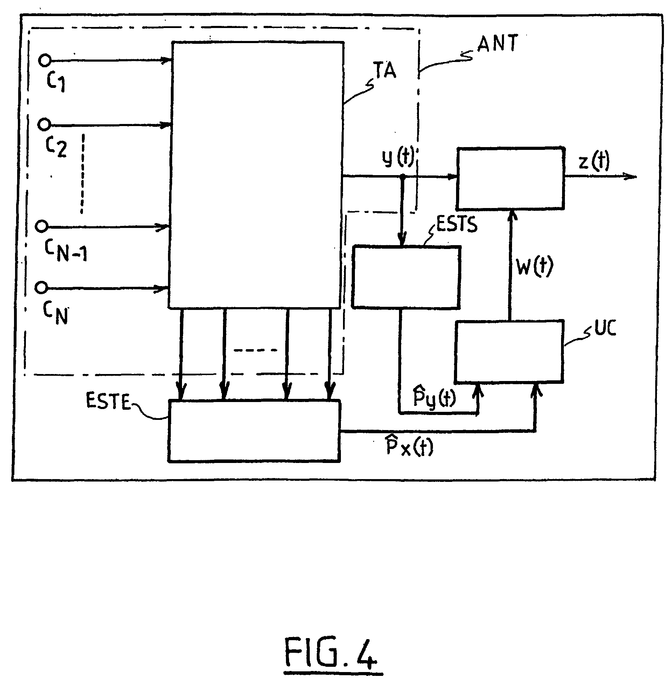

Ainsi, à la Fig. 4, on a représenté un autre mode de réalisation d'un système d'antenne également prévu pour mettre en oeuvre le procédé de la présente invention. Il diffère du précédent en ce que l'estimation de la puissance d'entrée $P_q(t)$, dans le domaine temporel, ou $P_q(t,f)$, dans le domaine fréquentiel, (l'indice q utilisé est pour pouvoir distinguer ces estimations de l'estimation de puissance d'entrée $P_x(t)$ ou $P_x(t,f)$ réalisée par utilisation des signaux directement issus des capteurs $C_1$ à $C_N$) est réalisée à partir d'un certain nombre de ces signaux engendrés au sein même de l'unité de traitement d'antenne TA. Plus exactement, parmi les $J$ signaux utilisables au sein du traitement d'antenne, un seul signal, seulement quelques signaux, ou tous les signaux peuvent être utilisés pour estimer la puissance en entrée $P_q(t)$ ou $P_q(t,f)$.

L'estimation de la puissance en entrée $\hat{P}_x(t,f)$ peut être calculée à l'aide de la moyenne des $N$ densités spectrales de puissance des signaux respectivement présents sur les capteurs $C_1$ à $C_N$. De la même manière, la puissance en sortie d'antenne $P_y(t,f)$ peut être calculée à l'aide de la densité spectrale de puissance de $y(t)$. Par conséquent, le procédé objet de l'invention nécessite le calcul d'au plus $(N + 1)$ grandeurs spectrales au lieu $N(N + 1)/2$ dans le cas des procédés de l'art antérieur. Par exemple pour une antenne à 9 capteurs, 10 calculs de densité spectrale de puissance sont estimés au lieu de 36 calculs de densité interspectrale de puissance et 9 calculs de densité spectrale pour les méthodes antérieures.

Un autre avantage de la présente invention résulte du fait qu'elle n'est pas basée sur une estimation de la densité spectrale du signal utile si bien que le problème du biais dans l'estimation de la densité interspectrale de puissance du signal utile $\Phi_{ss}(f)$ ne se pose pas.

Un autre avantage résulte du fait que le procédé objet de l'invention n'est pas basé sur les propriétés inter-capteurs des signaux perturbateurs. On rappelle que dans les techniques antérieures, les densités interspectrales des bruits doivent être nulles pour que le bruit soit réduit efficacement par le post-filtre.

Prenons par exemple le cas d'une source perturbatrice localisée. Supposons que le signal qu'elle émet arrive sur l'antenne dans une direction autre que celle de la source utile et que par conséquent, l'antenne atténue ce signal. Ce signal parvenant à tous les capteurs de façon cohérente, il ne sera pas atténué par les procédés de l'art antérieur connus alors qu'il sera réduit avec un post-filtrage mis en oeuvre selon le procédé de l'invention du fait même de l'atténuation de ce signal apportée par l'antenne. Par sa nature algorithmique, le procédé objet de l'invention est robuste vis à vis de la nature statistique des perturbations puisque seule leur nature énergétique intervient dans la méthode.

Dans les méthodes antérieures, les densités interspectrales de puissance estimées à l'entrée sont employées pour estimer la densité spectrale de puissance du signal utile. Ceci implique qu'il est absolument nécessaire d'utiliser les signaux en sortie des filtres de compensation des retards (qui sont les filtres $FV_i$ représentés à la Fig. 2 et qui réalisent le pointage de l'antenne dans la direction de la source utile). Dans le procédé objet de l'invention, du fait qu'on estime directement la puissance du signal d'entrée (donc par exemple des densités spectrales de puissance), il n'est pas nécessaire d'utiliser les signaux de voie remis en phase et l'estimation peut se faire directement en sortie des capteurs.

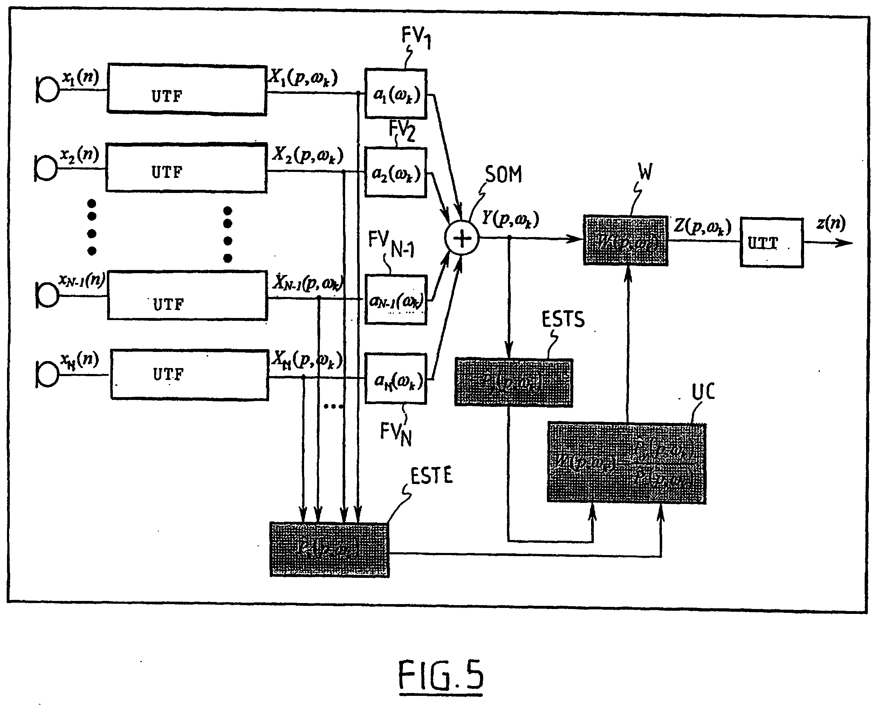

On va maintenant décrire un exemple d'application du procédé de la présente invention mis en oeuvre dans le domaine fréquentiel. Le système d'antenne est alors celui qui est représenté à la Fig. 5.

Chaque signal $x_i(n)$ délivré par un capteurs $C_i$ (i = 1 à N) est soumis (classiquement dans le domaine du traitement numérique du signal) à une transformée dans le domaine temporel dans une unité UTF. Par exemple, ladite transformée est une transformée de Fourier à court terme (ou encore dit à "fenêtre temporelle glissante") qui elle-même peut consister en une opération de fenêtrage puis à une transformée de Fourier rapide. Il pourrait également s'agir d'une transformée en ondelettes.

L'expresssion de chaque signal microphonique $C_i$ (i pouvant prendre les valeurs 1 à N) à l'issue de cette transformation dans le domaine fréquentiel peut s'écrire

$$X_i(p,\omega_k) = \sum_{n=0}^{M-1} h_a(-n)x_i(pR+n)W_M^{-kn} \qquad k = 0,...,M-1 \qquad (18)$$

Les notations utilisées sont les suivantes :

- $h_a(n)$ : fenêtre d'analyse de longueur $M$.
- $M$ : longueur de la fenêtre d'analyse (exprimée en nombre d'échantillons).
- $R$ : pas de décalage des fenêtres (en échantillons).
- $p$ : indice de trame correspondant à un instant $t$ et de durée égale à celle de la longueur M de la fenêtre d'analyse.
- L'axe des fréquences étant discrétisé de façon uniforme, on note la $k^{ieme}$ composante :

$$\omega_k = 2\,\pi k/M \qquad k = 0,..., M\text{-}1 \tag{19}$$

et

$$W_M = e^{j2\pi/M} = e^{j\omega_1} \tag{20}$$

On notera que $\omega_k$ est la représentation discrète de la fréquence $f$ à valeurs continues.

Le signal $Y(p, \omega_k)$ en sortie de l'antenne ANT est obtenu en effectuant la somme, dans l'unité SOM, des signaux $X_i(p,\omega_k)$ issus des microphones $C_i$ (i = 1 à N) respectivement soumis à des filtres de voie $FV_i$ de fonction de transfert $\alpha_i(\omega_k)$. Son expression s'écrit donc :

$$Y(p,\omega_k)=\sum_{i=1}^{N} a_i(\omega_k)X_i(p,\omega_k) \tag{21}$$

On comprendra que, comme cela a déjà été mentionné dans le préambule de la présente description, chaque fonction de transfert $a_i(\omega_k)$ inclut non seulement la fonction de le contrôle de directivité mais aussi celle de compensation de retard.

Le signal $Z(p,\omega_k)$ à l'issu du post-filtrage de fonction $W(p,\omega_k)$ mis en oeuvre dans le postfiltre W est donné par la relation :

$$Z(p,\omega_k) = Y(p,\omega_k).W(p,\omega_k) \tag{22}$$

Enfin, le signal $z(n)$ de sortie du système d'antenne est obtenu par retour dans le domaine temporel dans une unité de transformation dans le domaine temporel UTT. Cette unité de transformation UTT est par exemple constituée d'une transformation de Fourier inverse et d'une opération de fenêtrage. Il pourrait également s'agir d'une transformée inverse en ondelettes

Le signal $z(n)$ est alors donné par la relation suivante :

$$z(n)=\sum_{p=-\infty}^{p=+\infty} h_s(n-pR)\frac{1}{M}\sum_{k=0}^{M-1}Z(p,\omega_k)W_M^{k(n-pR)} \qquad n=0,...,M\text{-}1 \tag{23}$$

où $h_s(n)$ est la fenêtre de synthèse de longueur $M$.

Cette méthode particulière de mise en oeuvre fait partie de la famille des techniques de réductions des perturbations (i.e. bruit ambiant, réverbération, écho acoustique, etc..) par modification spectrale à court terme. Pour ce faire, le traitement est réalisé par bloc par fenêtre temporelle glissante. Toutes les variantes de ces approches peuvent être utilisées pour mettre en oeuvre le procédé objet de l'invention

La fonction $W(p,\omega_k)$ du post-filtre est obtenue par le rapport de l'estimation $\hat{P}_y(p,\omega_k)$ de la puissance du signal de sortie de l'antenne sur l'estimation $P_x(p,\omega_k)$ de la puissance du signal d'entrée et est donc donnée par la relation suivante :

$$W(p,\omega_k)=\frac{\hat{P}_y(p,\omega_k)}{P_x(p,\omega_k)} \tag{24}$$

Comme cela a déjà été mentionné, il est possible d'appliquer au post-filtre des transformations linéaires ou non-linéaires. Ceci est par exemple le cas pour s'affranchir des erreurs d'estimation dans des contextes particuliers (aux fréquences où le post-filtre prend des valeurs en dehors d'un intervalle prédéterminé, par exemple [0; 1]. Il est alors nécessaire d'appliquer une fonction de limitation à seuil pour éviter des amplification non souhaitées). On peut également vouloir privilégier certaines valeurs proches de la valeur maximale que peut prendre la fonction du post-filtre et vouloir réduire plus fortement les valeurs proches de la valeur minimale que peut prendre la fonction du postfiltre.

L'estimation de la puissance du signal en entrée $P_x(p,\omega_k)$ est réalisée, dans l'unité ESTE, par la moyenne de l'estimation des densités spectrales de puissance des signaux issus des microphones $C_1$ à $C_N$ :

$$\hat{P}_x(p,\omega_k)=\sum_{i=1}^{N}\hat{\Phi}_{x_ix_i}(p,\omega_k) \tag{25}$$

On notera que la détermination de cette puissance pourrait n'utiliser que les signaux que d'un ou de certains capteurs $C_1$ à $C_N$.

Quant à l'estimation de la puissance du signal en sortie d'antenne $\hat{P}_y(p,\omega_k)$, elle est réalisée par l'unité ESTS et est donnée par l'estimation de la densité spectrale de puissance de ce signal :

$$\hat{P}_y(p,\omega_k)=\hat{\Phi}_{yy}(p,\omega_k) \tag{25}$$

L'unité UC calcule la fonction du postfiltre $W(p,\omega_k)$ et la fournit au postfiltre W lui-même.

Les estimées des densités spectrales $\Phi_{x_ix_i}(p,\omega_k)$ et $\Phi_{yy}(p,\omega_k)$ doivent répondre à un compromis entre une estimation à long-terme, donnant une variance faible, et une mise à jour rapide du post-filtre de fonction $W(p,\omega_k)$ qui doit assurer une poursuite des variations temporelles des signaux mis en jeu.

On utilisera, à titre d'exemple, une méthode d'estimation récursive par un lissage à oubli exponentiel qui assure ce compromis et qui se calcule simplement à l'aide des équations récursives suivantes :

$$\hat{\Phi}_{x_ix_i}(p,\omega_k)=\alpha\hat{\Phi}_{x_ix_i}(p-1,\omega_k)+X_i(p,\omega_k)X^*_i(p,\omega_k) \tag{27}$$

et

$$\hat{\Phi}_{yy}(p,\omega_k)=\alpha\hat{\Phi}_{yy}(p-1,\omega_k)+Y(p,\omega_k)Y^*(p,\omega_k) \tag{28}$$

où $\alpha$ est un nombre proche de 1 qui est lié à la constante de temps $\tau$ du lissage exponentiel par la relation suivante :

$$\alpha=e^{-R/(\tau Fe)} \tag{29}$$

où *Fe* est la fréquence d'échantillonnage et R le pas de décalage des fenêtres (en échantillons).

On notera que la somme des pondérations des deux termes du second membre des équations des estimés ci-dessus n'est pas égale à l'unité. Ceci s'explique par l'expression du post-filtre sous forme qui permet de s'affranchir de la pondération usuelle de l'un des deux termes par $(1-\alpha)$.

On a mis en oeuvre le procédé de l'invention tel qu'il vient d'être décrit avec une antenne acoustique réalisée pour des applications de communication interactive à partir d'ordinateurs individuels. Cette antenne acoustique est disposée sur le moniteur d'un ordinateur individuel. Elle est constituée de 9 microphones $C_1$ à $C_9$ de type cardioïde disposés linéairement sur une longueur de 40 cm. Cette antenne est conçue de manière à être constituée de quatre sous-antennes respectivement dédiées aux basses fréquences, aux fréquences moyennes basses, aux fréquences moyennes hautes et aux hautes fréquences et, ce, dans la bande téléphonique élargie [50 Hz - 7 kHz].

La première sous-antenne est constituée des capteurs $C_1$, $C_3$, $C_9$ dont les espacements entre capteurs contigus est de 20 cm. Sur le signal de chacun de ces capteurs, est appliqué un filtrage de limitation de bande de caractéristique donnée par la fonction $g_1(f)$.

La seconde sous-antenne est constituée des capteurs $C_1$, $C_2$, $C_3$, $C_8$, $C_9$ dont les espacements entre capteurs contigus est de 10 cm. Sur le signal de chacun de ces capteurs, est appliqué un filtrage de limitation de bande de caractéristique donnée par la fonction $g_2(f)$.

La troisième sous-antenne est constituée des capteurs $C_2$, $C_3$, $C_5$, $C_7$, $C_8$ dont les espacements entre capteurs contigus est de 5 cm. Sur le signal de chacun de ces capteurs, est appliqué un filtrage de limitation de bande de caractéristique donnée par la fonction $g_3(f)$.

La quatrième sous-antenne est constituée des capteurs $C_3$, $C_4$, $C_5$, $C_6$, $C_7$ dont les espacements entre capteurs contigus est de 2,5 cm. Sur le signal de chacun de ces capteurs, est appliqué un filtrage de limitation de bande de caractéristique donnée par la fonction $g_4(f)$.

On comprendra que, le microphone $C_1$ appartenant à la fois aux deux premières sous-antennes, le signal qu'il délivre est soumis, dans un filtre de voie $FV_1$, à un filtrage de limitation de bande de caractéristique donnée par la fonction somme des deux fonctions caractéristiques de ces sous-antennes $g_1(t) + g_2(t)$.

Ainsi, les filtres de voie $FV_1$ à $FV_9$ sont respectivement des fonctions de transfert $a_1(t)$ à $a_9(t)$ qui sont définies par les relations suivantes :

$$a_1(t) = a_9(t) = g_1(t) + g_2(t)$$

$$a_2(t) = a_8(t) = g_2(t) + g_3(t)$$

$$a_3(t) = a_7(t) = g_3(t) + g_4(t)$$

$$a_4(t) = a_6(t) = g_4(t)$$

$$a_5(t) = g_1(t) + g_2(t) + g_3(t) + g_4(t)$$

Ces filtres assurent un contrôle de directivité correspondant au contexte de prise de son pour station de travail, avec un pointage de l'antenne en face de l'écran d'ordinateur, ouverture de lobe principal constant (angle d'ouverture à -3 dB de 20°) et remontée des lobes secondaires inférieure à - 12 dB par rapport au maximun du lobe principal.

On comprendra que ces filtres $FV_1$ à $FV_9$ sont mis en oeuvre dans le domaine fréquentiel comme cela a été explicité ci-dessus en relation avec la Fig. 5.

On va illustrer les performances d'un système d'antenne tel qu'il vient d'être décrit en ce qui concerne la réduction d'écho acoustique. On considère que l'utilisateur de la machine sur laquelle est installé ledit système d'antenne (dit le locuteur local) est en communication mains-libres. Le son de la personne avec qui il communique (dit le locuteur distant) est diffusé sur un haut-parleur placé à droite du moniteur de ladite machine. L'écho acoustique à réduire est le signal qui est capté par l'antenne acoustique et qui résulte du son émis par ce haut-parleur. Cet écho est une perturbation très gênante car le locuteur distant entend sa propre parole décalée dans le temps (en raison du retard dans la chaîne de télécommunication). Lorsque le niveau de l'écho atteint une certaine valeur, il peut se créer un phénomène instable auto-entretenu qui va générer une oscillation connue sous le nom d'effet Larsen.

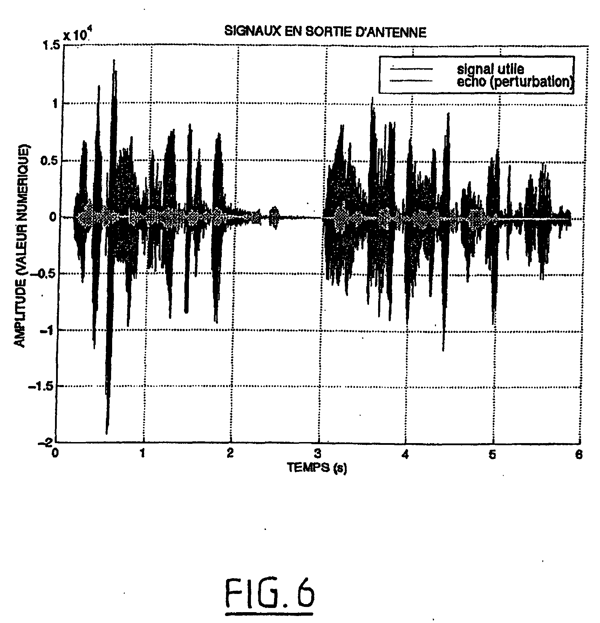

La Fig. 6 est un diagramme qui montre, en fonction du temps, l'amplitude des signaux en sortie d'une antenne telle que celle qui a été précédemment décrite mais sans l'unité de post-filtrage. En noir, est représentée la composante de parole utile émise par le locuteur local et en gris la composante de l'écho acoustique.

On notera que cette représentation permet d'illustrer les performances du système, mais dans la réalité signaux utiles et signaux d'écho sont superposés. On notera encore que les perturbations sont particulièrement adverses car les deux personnes parlent en même temps, excepté dans l'intervalle de temps [2,3 s; 3 s], et il y a donc simultanément présence de la perturbation et de la source utile. Le rapport signal utile à signal d'écho correspondant à cette expérience est de 10,4 dB en entrée d'antenne, valeur qui est mesurée sur le micro central de l'antenne.

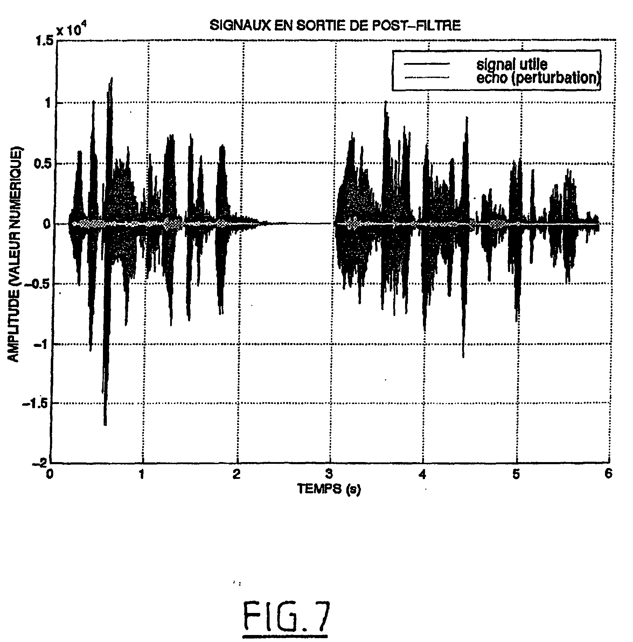

La Fig. 7 montre les mêmes signaux que ceux représentés à la Fig. 6 mais en sortie du post-filtre tel qu'il vient d'être décrit. On observe une réduction significative apportée par le post-filtre de l'écho encore présent en sortie d'antenne sans diminution du niveau du signal utile. Les valeurs des rapports signal utile à écho mesurées sont de 10,4 dB en entrée d'antenne, de 14 dB en sortie d'antenne et de 21 dB en sortie de post-filtre. Par conséquent le gain moyen en rapport signal à écho est de 4,6 dB pour l'antenne et de 7 dB pour le post-filtre, conférant au système une amélioration du rapport signal à écho de 11,6 dB.

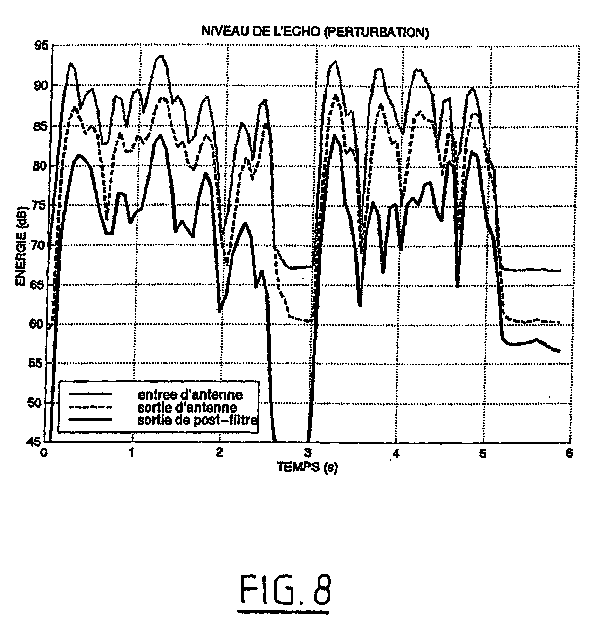

La Fig. 8 apporte une information sur la réduction de l'écho au cours du temps. Les courbes sont obtenues par mesure énergétique des signaux par blocs de 64 ms. On observe que le post-filtre accroît significativement les performances de l'antenne. De plus, aux instants où la parole locale n'est plus active, (intervalle de temps [2,3 s; 3 s]) l'écho résiduel en sortie d'antenne est réduit par le post-filtre de plus de 20 dB.

**Revendications**

1. Procédé d'amélioration du rapport de la puissance du signal utile à celle des signaux perturbateurs d'une antenne (ANT) comportant au moins un capteur ($C_1$ à $C_N$), **caractérisé en ce qu'**il consiste à filtrer le signal délivré par ladite antenne (ANT) au moyen d'un filtre (W) dont la fonction de transfert ($W(t), W(t,f)$) est égale au rapport de deux fonctions (F) et (G) linéaires de la puissance ($P_y(t), P_y(t,f)$) à la sortie de l'antenne (ANT) et de la puissance ($P_x(t), P_x(t,f)$) à l'entrée de l'antenne (ANT) :

$$W(t) = \frac{F\left(\hat{P}_x(t), \hat{P}_y(t)\right)}{G\left(\hat{P}_x(t), \hat{P}_y(t)\right)}$$

ou

$$W(t,f) = \frac{F\left(\hat{P}_x(t,f), \hat{P}_y(t,f)\right)}{G\left(\hat{P}_x(t,f), \hat{P}_y(t,f)\right)}$$

2. Procédé d'amélioration du rapport de la puissance du signal utile à celle des signaux perturbateurs selon la revendication 1, **caractérisé en ce que** ladite fonction de transfert ($W(t), W(t,f)$) est égale au rapport de la puissance ($P_y(t), P_y(t,f)$) du signal à la sortie de l'antenne (ANT) et de la puissance ($P_x(t), P_x(t,f)$) du ou des signaux respectivement délivrés par le ou les capteurs ($C_1$ à $C_N$) à l'entrée de l'antenne (ANT) :

$$W(t) = \frac{\hat{P}_y(t)}{P_x(t)} \text{ ou } W(t,f) = \frac{\hat{P}_y(t,f)}{P_x(t,f)}$$

3. Procédé d'amélioration du rapport de la puissance du signal utile à celle des signaux perturbateurs selon la revendication 1 ou 2, **caractérisé en ce qu'**il consiste à estimer la puissance ($P_y(t), P_y(t,f)$) du signal à la sortie de l'antenne (ANT) et la puissance ($P_x(t), P_x(t,f)$) du ou des signaux respectivement délivrés par le ou les capteurs ($C_1$ à $C_N$) à l'entrée de l'antenne (ANT).

4. Procédé d'amélioration du rapport de la puissance du signal utile à celle des signaux perturbateurs selon la revendication 3, **caractérisé en ce qu'**il consiste à utiliser, pour pouvoir estimer la puissance ($P_x(t), P_x(t,f)$) du ou des signaux respectivement délivrés par le ou les capteurs ($C_1$ à $C_N$) à l'entrée de l'antenne (ANT), le, des ou les signaux ($x_i(t)$, $i = 1$ à N) respectivement délivrés par le, des ou les capteurs ($C_1$ à $C_N$) de ladite antenne (ANT).

5. Procédé d'amélioration du rapport de la puissance du signal utile à celle des signaux perturbateurs selon la revendication 3 ou 4, **caractérisé en ce qu'**il consiste à utiliser, pour pouvoir estimer la puissance ($P_x(t), P_x(t,f)$) du ou des signaux respectivement délivrés par le ou les capteurs ($C_1$ à $C_N$) à l'entrée de l'antenne (ANT), le ou des signaux issus du traitement, dans une unité de traitement d'antenne (TA) de ladite antenne (ANT), des signaux ($x_i(t)$, $i = 1$ à N) respectivement délivrés par les capteurs ($C_1$ à $C_N$) de ladite antenne (ANT).

6. Procédé de traitement d'antenne consistant à transformer dans le domaine fréquentiel le ou chaque signal délivré par au moins un capteur ($C_1$ à $C_N$), à filtrer le ou chaque signal issu de ladite transformation, à sommer entre eux les signaux respectivement obtenus après filtrage et à transformer dans le domaine temporel le signal obtenu après sommation, **caractérisé en ce qu'**il consiste à filtrer le signal délivré par ladite antenne (ANT) au moyen d'un filtre (W) dont la fonction de transfert ($W(t,f)$) est égale au rapport de deux fonctions (F) et (G) linéaires de la puissance ($P_y(t,f)$) à la sortie du sommateur (SOM) et de la puissance ($P_x(t,f)$) du ou des signaux délivrés par ladite ou lesdites unités de transformation dans le domaine fréquentiel (UTF) :

$$W(t,f) = \frac{F\left(\hat{P}_x(t,f), \hat{P}_y(t,f)\right)}{G\left(\hat{P}_x(t,f), \hat{P}_y(t,f)\right)}$$

**7.** Procédé de traitement d'antenne selon la revendication 6, **caractérisé en ce que** ladite fonction de transfert ($W(t,f)$) est égale au rapport de la puissance ($P_y(t,f)$) du signal à la sortie du sommateur (SOM) et de la puissance ($P_x(t,f)$) du ou des signaux délivrés par ladite ou lesdites unités de transformation dans le domaine fréquentiel (UTF) :

$$W(t,f) = \frac{\hat{P}_y(t,f)}{\hat{P}_x(t,f)}$$

**8.** Procédé de traitement d'antenne selon la revendication 6 ou 7, **caractérisé en ce qu'**il consiste à estimer la puissance ($P_y(t,f)$) du signal à la sortie de l'antenne (ANT) et la puissance ($P_x(t,f)$) du ou des signaux respectivement délivrés par le ou les capteurs ($C_1$ à $C_N$) à l'entrée de l'antenne (ANT).

**9.** Procédé de traitement d'antenne selon la revendication 6, 7 ou 8, **caractérisé en ce que**, pour effectuer l'estimation de la puissance ($P_x(t,f)$) du ou des signaux respectivement délivrés par le ou les capteurs ($C_1$ à $C_N$) à l'entrée de l'antenne (ANT), il consiste à effectuer la moyenne de l'estimation des densités spectrales de puissance $\Phi_{(x_i x_i}(t,f))$ des signaux issus du ou des capteurs ($C_1$ à $C_N$) :

$$\hat{P}_x(t,f) = \sum_{i=1}^{N} \hat{\Phi}_{x_i x_i}(t,f)$$

**10.** Procédé de traitement d'antenne selon la revendication 8 ou 9, **caractérisé en ce que**, pour effectuer l'estimation ($P_y(t,f)$) de la puissance ($P_y(t,f)$) du signal en sortie du sommateur (SOM), il consiste à calculer l'estimation de la densité spectrale de puissance ($\Phi_{yy}(t,f)$) de ce signal :

$$\hat{P}_y(t,f) = \hat{\Phi}_{yy}(t,f)$$

**11.** Procédé de traitement d'antenne selon une des revendications 8 à 10, **caractérisé en ce qu'**il consiste à effectuer lesdites estimations de manière récursive par lissage à oubli exponentiel.

**12.** Système d'antenne comprenant une antenne (ANT) pourvue d'au moins un capteur ($C_1$ à $C_N$) et prévu pour améliorer le rapport signal utile à signaux perturbateurs de ladite antenne (ANT), **caractérisé en ce qu'**il comprend un filtre (W) qui est prévu pour filtrer le signal délivré par ladite antenne (ANT) et dont la fonction de transfert ($W(t), W(t,f)$) est égale au rapport de deux fonctions (F) et (G) linéaires de la puissance ($P_y(t), P_y(t,f)$) à la sortie de l'antenne (ANT) et de la puissance ($P_x(t), P_x(t,f)$) à l'entrée de l'antenne (ANT) :

$$W(t) = \frac{F\left(\hat{P}_x(t), \hat{P}_y(t)\right)}{G\left(\hat{P}_x(t), \hat{P}_y(t)\right)}$$

ou

$$W(t,f) = \frac{F\left(\hat{P}_x(t,f), \hat{P}_y(t,f)\right)}{G\left(\hat{P}_x(t,f), \hat{P}_y(t,f)\right)}$$

**13.** Système selon la revendication 12, **caractérisé en ce que** ladite fonction de transfert (*W(t), W(t,f)*) dudit filtre (W) est égale au rapport de la puissance ($P_y(t)$, $P_y(t,f)$) du signal à la sortie de l'antenne (ANT) et de la puissance ($P_x(t)$, $P_x(t,f)$) du ou des signaux respectivement délivrés par le ou les capteurs ($C_1$ à $C_N$) à l'entrée de l'antenne (ANT) :

$$W(t)=\frac{\hat{P}_y(t)}{P_x(t)} \text{ ou } W(t,\,f)=\frac{\hat{P}_y(t,\,f)}{P_x(t,\,f)}$$

**14.** Système d'antenne selon la revendication 12 ou 13, **caractérisé en ce qu'**il comporte des unités d'estimations (ESTE, ESTS) pour pouvoir respectivement estimer la puissance ($P_y(t)$, $P_y(t,f)$) du signal présent à la sortie de l'antenne (ANT) et la puissance ($P_x(t)$, $P_x(t,f)$) du ou des signaux délivrés par le ou lesdits capteurs ($C_1$ à $C_N$) à l'entrée de l'antenne (ANT).

**15.** Système d'antenne selon la revendication 14, **caractérisé en ce que** ladite unité d'estimation (ESTE), pour pouvoir estimer la puissance ($P_x(t)$, $P_x(t,f)$) à l'entrée de l'antenne (ANT), traite le, des ou les signaux ($x_i(t)$, $i = 1$ à N) respectivement délivrés par un, des ou les capteurs ($C_1$ à $C_N$) de ladite antenne (ANT).

**16.** Système d'antenne selon une des revendications 14 ou 15, **caractérisé en ce que** ladite unité d'estimation (ESTE) traite, pour pouvoir estimer la puissance ($P_x(t)$, $P_x(t,f)$) à l'entrée de l'antenne (ANT), le ou des signaux délivrés par une unité de traitement d'antenne (TA) de ladite antenne (ANT) à partir des signaux ($x_i(t)$, $i = 1$ à N) respectivement délivrés par les capteurs ($C_1$ à $C_N$) de ladite antenne (ANT).

**17.** Système d'antenne comprenant une unité (UTF) de transformation dans le domaine fréquentiel du ou de chaque signal délivré par au moins un capteur ($C_i$ avec $i = 1$ à N), un filtre de voie ($FV_i$) pour filtrer dans le domaine fréquentiel le signal délivré par ladite unité de transformation (UTF), un sommateur (SOM) pour sommer entre eux les signaux respectivement délivrés par lesdits filtres de voie ($FV_i$) et une unité (UTT) de transformation dans le domaine temporel du signal délivré par ledit sommateur (SOM), **caractérisé en ce qu'**il comporte, entre le sommateur (SOM) et l'unité de transformation dans le domaine temporel (UTT), un filtre (W) dont la fonction de transfert (*W(t,f)*) est égale au rapport de deux fonctions (F) et (G) linéaires de la puissance ($P_y(t,f)$) du signal présent à la sortie du sommateur (SOM) et de la puissance ($P_x(t,f)$) du ou des signaux délivrés par ladite unité de transformation dans le domaine fréquentiel (UTF):

$$W(t,f) = \frac{F\left(\hat{P}_x(t,f),\hat{P}_y(t,f)\right)}{G\left(\hat{P}_x(t,f),\hat{P}_y(t,f)\right)}$$

**18.** Système selon la revendication 17, **caractérisé en ce que** ladite fonction de transfert (*W(t,f)*) dudit filtre (W) est égale au rapport de la puissance ($P_y(t,f)$) du signal à la sortie du sommateur (SOM) et de la puissance ($P_x(t,f)$) du ou des signaux délivrés par ladite unité de transformation dans le domaine fréquentiel (UTF) :

$$W(t,f)=\frac{\hat{P}_y(t,\,f)}{P_x(t,\,f)}$$

**19.** Système d'antenne selon la revendication 17 ou 18, **caractérisé en ce qu'**il comporte des unités d'estimations (ESTE, ESTS) pour pouvoir respectivement estimer la puissance ($P_y(t,f)$) du signal présent à la sortie du sommateur (SOM) et la puissance ($P_x(t,f)$) du ou des signaux délivrés par lesdites unités de transformation

**20.** Système d'antenne selon la revendication 19, **caractérisé en ce que** ladite unité d'estimation (ESTE) pour l'estimation de la puissance ($P_x(t,f)$) du ou des signaux respectivement délivrés par le ou les capteurs ($C_1$ à $C_N$) à l'entrée de l'antenne (ANT) effectue la moyenne de l'estimation des densités spectrales de puissance ($\Phi_{x_i x_i}(t,f)$) des signaux issus du ou des capteurs ($C_1$ à $C_N$):

$$\hat{P}_x(t,f) = \sum_{i=1}^{N} \hat{\Phi}_{x_i x_i}(t,f)$$

**21.** Système d'antenne selon la revendication 19 ou 20, **caractérisé en ce que** ladite unité d'estimation (ESTS) pour l'estimation de la puissance ($P_y(t,f)$) du signal en sortie du sommateur (SOM) est donnée par l'estimation ($\Phi_{yy}(t, f)$) de la densité spectrale de puissance de ce signal :

$$\hat{P}_y(t,f) = \hat{\Phi}_{yy}(t,f)$$

**22.** Système d'antenne selon une des revendications 19 à 21, **caractérisé en ce qu'**il comporte des moyens pour que lesdites estimations soient effectuées de manière récursive par lissage à oubli exponentiel.

## Claims

**1.** Process for improving the ratio of the power of the wanted signal to that of the interfering signals of an antenna (ANT) comprising at least one sensor ($C_1$ to $C_N$), **characterized in that** it consists in filtering the signal delivered by the said antenna (ANT) by means of a filter (W) whose transfer function ($W(t)$, $W(t,f)$) is equal to the ratio between two linear functions (F) and (G) of the power ($P_y(t)$, $P_y(t,f)$) at the output of the antenna (ANT) and the power ($P_x(t)$, $P_x(t,f)$) at the input of the antenna (ANT):

$$W(t) = \frac{F(\hat{P}_x(t), \hat{P}_y(t))}{G(P_x(t), P_y(t))}$$

or

$$W(t,f) = \frac{F(\hat{P}_x(t, f), \hat{P}_y(t, f))}{G(P_x(t, f), P_y(t, f))}$$

**2.** Process for improving the ratio of the power of the wanted signal to that of the interfering signals according to Claim 1, **characterized in that** the said transfer function ($W(t)$, $W(t,f)$) is equal to the ratio of the power ($P_y(t)$, $P_y(t,f)$) of the signal at the output of the antenna (ANT) to the power ($P_x(t)$, $P_x(t,f)$) of the signal or signals delivered by the sensor or sensors ($C_1$ to $C_N$) respectively at the input of the antenna (ANT):

$$W(t) = \frac{\hat{P}_y(t)}{P_x(t)} \text{ or } W(t,f) = \frac{\hat{P}_y(t, f)}{P_x(t, f)}$$

**3.** Process for improving the ratio of the power of the wanted signal to that of the interfering signals according to Claim 1 or 2, **characterized in that** it consists in estimating the power ($P_y(t)$, $P_y(t,f)$) of the signal at the output of the antenna (ANT) and the power ($P_x(t)$, $P_x(t,f)$) of the signal or signals delivered by the sensor or sensors ($C_1$ to $C_N$) respectively at the input of the antenna (ANT).

**4.** Process for improving the ratio of the power of the wanted signal to that of the interfering signals according to Claim 3, **characterized in that** it consists in using, in order to estimate the power ($P_x(t)$, $P_x(t,f)$) of the signal or signals delivered by the sensor or sensors ($C_1$ to $C_N$) respectively at the input of the antenna (ANT), the signal or some or all of the signals ($x_i(t)$, $i$ = 1 to N) delivered by the sensor or some or all of the sensors ($C_1$ to $C_N$) respectively of the antenna (ANT).

**5.** Process for improving the ratio of the power of the wanted signal to that of the interfering signals according to Claim 3 or 4, **characterized in that** it consists in using, in order to estimate the power ($P_x(t)$, $P_x(t, f)$) of the signal or signals delivered by the sensor or sensors ($C_1$ to $C_N$) respectively at the input of the antenna (ANT), the signal or signals originating from the processing, in an antenna processing unit (TA) of the said antenna (ANT), of the signals ($x_i(t)$, $i$ = 1 to N) delivered by the sensors ($C_1$ to $C_N$) respectively of the antenna (ANT).

**6.** Antenna processing process consisting in transforming in the frequency domain the signal or each signal delivered by at least one sensor ($C_1$ to $C_N$), filtering the signal or each signal resulting from the said transformation, adding together the signals obtained after filtering, and transforming in the time domain the signal obtained after addition, **characterized in that** it consists in filtering the signal delivered by the said antenna (ANT) by means of a filter (W) whose transfer function ($W(t,f)$) is equal to the ratio between two linear functions (F) and (G) of the power ($P_y(t,f)$) at the output of the adder (SOM) and the power ($P_x(t,f)$) of the signal or signals delivered by the said frequency domain transformation unit or units (UTF):

$$W(t,f) = \frac{F(\hat{P}_x(t,f), \hat{P}_y(t,f))}{G(P_x(t,f), P_y(t,f))}$$

**7.** Antenna processing process according to Claim 6, **characterized in that** the said transfer function ($W(t,f)$) is equal to the ratio of the power ($P_y(t,f)$) of the signal at the output of the adder (SOM) to the power ($P_x(t,f)$) of the signal or signals delivered by the said frequency domain transformation unit or units (UTF):

$$W(t,f) = \frac{\hat{P}_y(t,f)}{P_x(t,f)}$$

**8.** Antenna processing process according to Claim 6 or 7, **characterized in that** it consists in estimating the power ($P_y(t,f)$) of the signal at the output of the antenna (ANT) and the power ($P_x(t,f)$) of the signal or signals delivered by the sensor or sensors ($C_1$ to $C_N$) respectively at the input of the antenna (ANT).

**9.** Antenna processing process according to Claim 6, 7 or 8, **characterized in that**, for the purpose of estimating the power ($P_x(t,f)$) of the signal or signals delivered by the sensor or sensors ($C_1$ to $C_N$) respectively at the input of the antenna (ANT), it consists in finding the mean of the estimation of the power spectral densities $\Phi_{(x_i x_i}(t,f))$ of the output signals from the sensor or sensors ($C_1$ to $C_N$):

$$\hat{P}_x(t,f) = \sum_{i=1}^{N} \hat{\Phi}_{x_i x_i}(t,f)$$

**10.** Antenna processing process according to Claim 8 or 9, **characterized in that**, for the purpose of estimating ($\hat{P}_y(t,f)$) the power ($P_y(t,f)$) of the signal at the output of the adder (SOM), it consists in calculating the estimated power spectral density ($\Phi_{yy}(t,f)$) of this signal:

$$\hat{P}_y(t,f) = \hat{\Phi}_{yy}(t,f)$$

**11.** Antenna processing process according to one of Claims 8 to 10, **characterized in that** it consists in carrying out the said estimations in a recursive way by smoothing by means of exponential forgetting.

**12.** Antenna system comprising an antenna (ANT) provided with at least one sensor ($C_1$ to $C_N$) and designed to improve the ratio of the wanted signal to the interference signals of the said antenna (ANT), **characterized in that** it comprises a filter (W) which is designed to filter the signal delivered by the said antenna (ANT) and whose transfer function ($W(t)$, $W(t,f)$) is equal to the ratio of two linear functions (F) and (G) of the power ($P_y(t)$,$P_y(t,f)$) at the output of the antenna (ANT) and the power ($P_x(t)$,$P_x(t,f)$) at the input of the antenna (ANT):

$$W(t) = \frac{F(\hat{P}_x(t), \hat{P}_y(t))}{G(P_x(t), P_y(t))}$$

or

$$W(t,f) = \frac{F(\hat{P}_{\wedge x}(t, f), \hat{P}_{\wedge y}(t, f))}{G(P_x(t, f), P_y(t, f))}$$

**13.** System according to Claim 12, **characterized in that** the said transfer function ($W(t)$, $W(t,f)$) of the said filter (W) is equal to the ratio of the power ($P_y(t)$, $P_y(t,f)$) of the signal at the output of the antenna (ANT) to the power ($P_x(t)$, $P_x(t,f)$) of the signal or signals delivered by the sensor or sensors ($C_1$ to $C_N$) respectively at the input of the antenna (ANT):

$$W(t) = \frac{\hat{P}_{\wedge y}(t)}{P_x(t)} \text{ or } W(t,f) = \frac{\hat{P}_{\wedge y}(t, f)}{P_x(t, f)}$$

**14.** Antenna system according to Claim 12 or 13, **characterized in that** it comprises estimation units (ESTE, ESTS) for estimating, respectively, the power ($P_y(t)$, $P_y(t,f)$) of the signal at the output of the antenna (ANT) and the power ($P_x(t)$, $P_x(t,f)$) of the signal or signals delivered by the sensor or sensors ($C_1$ to $C_N$) respectively at the input of the antenna (ANT).

**15.** Antenna system according to Claim 14, **characterized in that** the said estimation unit (ESTE) estimates the power ($P_x(t)$, $P_x(t,f)$) at the input of the antenna (ANT) by processing the signal or same or all of the signals ($x_i(t)$, $i = 1$ to N) delivezed respectively by a sensor or some or all of the sensors ($C_1$ to $C_N$) of the said antenna (ANT).

**16.** Antenna system according to one of Claims 14 and 15, **characterized in that** the said estimation unit (ESTE) estimates the power ($P_x(t)$, $P_x(t,f)$) at the input of the antenna (ANT) by processing the signal or signals delivered by an antenna processing unit (TA) of the said antenna (ANT) on the basis of the signals ($x_i(t)$, $i = 1$ to N) delivered respectively by the sensors ($C_1$ to $C_N$) of the said antenna (ANT).

**17.** Anterma system comprising a unit (UTF) for transformation in the frequency domain of the signal or of each signal delivered by at least one sensor ($C_i$ where $i = 1$ to N), a channel filter ($FV_i$) for filtering in the frequency domain the signal delivered by the said transformation unit (UTF), an adder (SOM) for adding together the signals delivered respectively by the said channel filters ($FV_i$) and a unit (UTT) for transformation in the time domain of the signal delivered by the said adder (SOM), **characterized in that** it comprises, between the adder (SOM) and the time domain transformation unit (UTT), a filter (W) whose transfer function ($W(t,f)$) is equal to the ratio of two linear functions (F) and (G) of the power ($P_y(t,f)$) of the signal present at the output of the adder (SOM) and of the power ($P_x(t,f)$) of the signal or signals delivered by the said frequency domain transformation unit (UTF):

$$W(t,f) = \frac{F(\hat{P}_{\wedge x}(t, f), \hat{P}_{\wedge y}(t, f))}{G(P_x(t, f), P_y(t, f))}$$

**18.** System according to Claim 17, **characterized in that** the said transfer function ($W(t,f)$) of the said filter (W) is equal to the ratio of the power ($P_y(t,f)$) of the signal at the output of the adder (SOM) to the power ($P_x(t,f)$) of the signal or signals delivered by the said frequency domain transformation unit (UTF):

$$W(t,f) = \frac{\hat{P}_{\wedge y}(t, f)}{P_x(t, f)}$$

**19.** Antenna system according to Claim 17 or 18, **characterized in that** it comprises estimation units (ESTE, ESTS) for estimating, respectively, the power ($P_y(t,f)$) of the signal present at the output of the adder (SOM) and the power ($P_x(t,f)$) of the signal or signals delivered by the said transformation units (UTF).

**20.** Antenna system according to Claim 19, **characterized in that** the said estimation unit (ESTE) estimates the power ($P_x(t,f)$) of the signal or signals delivered by the sensor or sensors ($C_1$ to $C_N$) respectively at the input of the antenna (ANT), by finding the mean of the estimation of the power spectral densities $\Phi_{(x_i x_i}(t,f))$ of the output signals from the sensor or sensors ($C_1$ to $C_N$):

$$\hat{P}_x(t,f) = \sum_{i=1}^{N} \hat{\Phi}_{x_i x_i}(t,f)$$

**21.** Antenna system according to Claim 19 or 20, **characterized in that** the said estimation unit (ESTS) for estimating the power ($P_y(t,f)$) of the signal at the output of the adder (SOM) is provided by the estimation ($\Phi_{yy}(t,f)$) of the power spectral density of this signal:

$$\hat{P}_y(t,f) = \hat{\Phi}_{yy}(t,f)$$

**22.** Antenna system according to one of Claims 19 to 21, **characterized in that** it comprises means for carrying out the said estimations in a recursive way by smoothing by means of exponential forgetting.

**Patentansprüche**

**1.** Verfahren zur Verbesserung des Verhältnisses der Leistung des Nutzsignals zu jener der Störsignale einer Antenne (ANT), umfassend mindestens einen Fühler ($C_1$ bis $C_N$), **dadurch gekennzeichnet, daß** es darin besteht, das von der Antenne (ANT) gelieferte Signal mit Fülfe eines Filters (W) zu filtern, dessen Übertragungsfunktion ($W(t)$, $W(t,f)$) gleich dem Verhältnis zweier linearer Funktionen (F) und (G) der Leistung ($P_y(t)$, $P_y(t,f)$) am Ausgang der Antenne (ANT) und der Leistung ($P_x(t)$, $P_x(t,f)$) am Eingang der Antenne (ANT) ist:

$$W(t) = \frac{F\left(\hat{P}_x(t), \hat{P}_y(t)\right)}{G\left(\hat{P}_x(t), \hat{P}_y(t)\right)}$$

oder

$$W(t,f) = \frac{F\left(\hat{P}_x(t,f), \hat{P}_y(t,f)\right)}{G\left(\hat{P}_x(t,f), \hat{P}_y(t,f)\right)}$$

**2.** Verfahren zur Verbesserung des Verhältnisses der Leistung des Nutzsignals zu jener der Störsignale nach Anspruch 1, **dadurch gekennzeichnet, daß** die Übertragaungsfunktion ($W(t)$, $W(t,f)$) gleich dem Verhältnis der Leistung ($P_y(t)$, $P_y(t,f)$) des Signals am Ausgang der Antenne (ANT) und der Leistung ($P_x(t)$, $P_x(t,f)$) des Signals oder der Signale ist, die von dem bzw. den Fühlern ($C_1$ bis $C_N$) an den Eingang der Antenne (ANT) geliefert werden:

$$W(t) = \frac{\hat{P}_y(t)}{P_x(t)} \text{ oder } W(t,f) = \frac{\hat{P}_y(t,f)}{P_x(t,f)}$$

**3.** Verfahren zur Verbesserung des Verhältnisses der Leistung des Nutzsignals zu jener der Störsignale nach Anspruch 1 oder 2, **dadurch gekennzeichnet, daß** es darin besteht, die Leistung ($P_y(t)$, $P_y(t,f)$) des Signals am Ausgang der Antenne (ANT) und die Leistung ($P_x(t)$, $P_x(t,f)$) des Signals oder der Signale, das oder die von dem bzw. den Fühlern ($C_1$ bis $C_N$) an den Eingang der Antenne (ANT) geliefert werden, zu bewerten.

**4.** Verfahren zur Verbesserung des Verhältnisses der Leistung des Nutzsignals zu jener der Störsignale nach Anspruch 3, **dadurch gekennzeichnet, daß** es darin besteht, die Leistung ($P_x(t)$, $P_x(t,f)$) des Signals oder der Signale, die von dem bzw. den Fühlern ($C_1$ bis $C_N$) an den Eingang der Antenne (ANT) geliefert werden, bewerten zu können, um das, einige oder die Signale ($x_i(t)$, i = 1 bis N), das oder die von dem, einigen oder den Fühlern ($C_1$ bis $C_N$) der Antenne (ANT) geliefert werden, zu verwenden.

**5.** Verfahren zur Verbesserung des Verhältnisses der Leistung des Nutzsignals zu jener der Störsignale nach Anspruch 3 oder 4, **dadurch gekennzeichnet, daß** es darin besteht, die Leistung $(P_x(t), P_x(t,f))$ des Signals oder der Signale, die von dem bzw. den Fühlern ($C_1$ bis $C_N$) an den Eingang der Antenne (ANT) geliefert werden, bewerten zu können, um das oder einige Signale, das oder die von der Verarbeitung in einer Antennenverarbeitungseinheit (TA) der Antenne (ANT) für die Signale ($x_i(t)$, $i$ = 1 bis N), die von den Fühlern ($C_1$ bis $C_N$) der Antenne (ANT) geliefert werden, stammt oder stammen, zu verwenden.

**6.** Verfahren zur Verarbeitung von Antennensignalen, darin bestehend, im Frequenzbereich das bzw. jedes Signal, das von mindestens einem Fühler ($C_1$ bis $C_N$) geliefert wird, zu transferieren, das bzw. jedes von dieser Umformung stammende Signal zu filtern, die nach dem Filtern erhaltenen Signale zu summieren und im Zeitbereich das nach der Summierung erhaltene Signal zu transferieren, **dadurch gekennzeichnet, daß** es darin besteht, das von der Antenne (ANT) gelieferte Signal mit Hilfe eines Filters (W) zu filtern, dessen Übertragungsfunktion $(W(t,f))$ gleich dem Verhältnis zweier linearer Funktionen (F) und (G) der Leistung $(P_y(t,f))$ am Ausgang des Summierer (SOM) und der Leistung $(P_x(t,f))$ des bzw. der Signale ist, das bzw. die von der bzw. den Transformationseinheiten im Frequenzbereich (UTF) geliefert werden:

$$W(t,f) = \frac{F\left(\hat{P}_x(t,f), \hat{P}_y(t,f)\right)}{G\left(\hat{P}_x(t,f), \hat{P}_y(t,f)\right)}$$

**7.** Verfahren zur Verarbeitung von Antennensignalen nach Anspruch 6, **dadurch gekennzeichnet, daß** die Übertragungsfunktion $(W(t,f))$ gleich dem Verhältnis der Leistung $(P_y(t,f))$ des Signals am Ausgang des Summierers (SOM) und der Leistung $(P_x(t,f))$ des oder der Signale ist, die von der bzw. den Transformataionseinheiten im Frequenzbereich (UTF) geliefert werden:

$$W(t,f) = \frac{\hat{P}_y(t,f)}{\hat{P}_x(t,f)}$$

**8.** Verfahren zur Verarbeitung von Antennensignalen nach Anspruch 6 oder 7, **dadurch gekennzeichnet, daß** es darin besteht, die Leistung $(P_y(t,f))$ des Signals am Ausgang der Antenne (ANT) und die Leistung $(P_x(t,f))$ des bzw. der Signale zu bewerten, die von dem oder den Fühlern ($C_1$ bis $C_N$) an den Eingang der Antenne (ANT) geliefert werden.

**9.** Verfahren zur Verarbeitung von Antennensignalen nach Anspruch 6, 7 oder 8, **dadurch gekennzeichnet, daß** es für die Durchführung der Bewertung der Leistung $(P_x(t,f))$ des oder der Signale, die von dem bzw. den Fühlern ($C_1$ bis $C_N$) an den Eingang der Antenne (ANT) geliefert werden, darin besteht, den Durchschnitt der Bewertung der Spektralleistungsdichten $(\Phi_{xixi}(t,f))$ der Signale, die von dem bzw. den Fühlern ($C_1$ bis $C_N$) stammen, festzustellen:

$$\hat{P}_x(t,f) = \sum_{i=1}^{N} \hat{\Phi}_{x_i x_i}(t,f)$$

**10.** Verfahren zur Verarbeitung von Antennensignalen nach Anspruch 8 oder 9, **dadurch gekennzeichnet, daß** es für die Durchführung der Bewertung der Leistung $(P_y(t,f))$ des Signals am Ausgang des Summierers (SOM) darin besteht, die Bewertung der Spektralleistungsdichten $(\Phi_{yy}(t,f))$ dieses Signals durchzuführen:

$$\hat{P}_y(t,f) = \hat{\Phi}_{yy}(t,f)$$

**11.** Verfahren zur Verarbeitung von Antennensignalen nach einem der Ansprüche 8 bis 10, **dadurch gekennzeichnet, daß** es darin besteht, diese Bewertungen rekursiv durch exponentielle Glättung durchzuführen.

**12.** Antennensystem, umfassend eine Antenne (ANT), die mit mindestens einem Fühler ($C_1$ bis $C_N$) versehen und dazu vorgesehen ist, das Verhältnis von Nutzsignal zu Störsignalen der Antenne (ANT) zu verbessern, **dadurch**

**gekennzeichnet, daß** es ein Filter (W) umfasst, der dazu vorgesehen ist, das von der Antenne (ANT) gelieferte Signal zu filtern, und dessen Übertragungsfunktion *(W(t), W(t,f)* gleich dem Verhältnis zweier linearer Funktionen (F) und (G) der Leistung *(P_y(t), P_y(t,f))* am Ausgang der Antenne (ANT) und der Leistung *(P_x(t), P_x(t,f))* am Eingang der Antenne (ANT) ist:

$$W(t) = \frac{F(\hat{P}_x(t),\ \hat{P}_y(t))}{G(P_x(t),\ P_y(t))}$$

oder

$$W(t,f) = \frac{F(\hat{P}_x(t,f),\ \hat{P}_y(t,f))}{G(P_x(t,f),\ P_y(t,f))}$$

**13.** System nach Anspruch 12, **dadurch gekennzeichnet, daß** die Übertragungsfunktion *(W(t), W(t,f))* des Filters (W) gleich dem Verhältnis der Leistung *(P_y(t), P_y(t,f))* des Signals am Ausgang der Antenne (ANT) und der Leistung *(P_x(t), P_x(t,f))* des oder der Signale, die von dem bzw. den Fühlern (C_1 bis C_N) an den Eingang der Antenne (ANT) geliefert werden, ist:

$$W(t) = \frac{\hat{P}_y(t)}{P_x(t)} \text{ oder } W(t,f) = \frac{\hat{P}_y(t,f)}{P_x(t,f)}$$

**14.** Antennensystem nach Anspruch 12 oder 13, **dadurch gekennzeichnet, daß** es Bewertungseinheiten (ESTE, ESTS) umfaßt, um die Leistung *(P_y(t), P_y(t,f))* des Signals, das am Ausgang der Antenne (ANT) vorhanden ist, und die Leistung *(P_x(t), P_x(t,f))* des oder der Signale bewerten zu können, die von dem bzw. den Fühlern (C_1 bis C_N) an den Eingang der Antenne (ANT) geliefert werden.

**15.** Antennensystem nach Anspruch 14, **dadurch gekennzeichnet, daß** die Bewertungseinheit (ESTE), um die Leistung *(P_x(t), P_x(t,f))* am Eingang der Antenne (ANT) bewerten zu können, das, einige oder die Signale *(x_i(t), i = 1 bis N)*, die von einem, einigen oder den Fühlern (C_1 bis C_N) der Antenne (ANT) geliefert werden, verarbeitet.

**16.** Antennensystem nach einem der Ansprüche 14 oder 15, **dadurch gekennzeichnet, daß** die Bewertungseinheit (ESTE), um die Leistung *(P_x(t), P_x(t,f))* am Eingang der Antenne (ANT) bewerten zu können, das oder einige Signale, die von einer Antennenverarbeitungseinheit (TA) der Antenne (ANT) aus den Signalen *(x_i(t), i = 1 bis N)* geliefert werden, die von dem oder den Fühlern (C_1 bis C_N) der Antenne (ANT) geliefert werden, verarbeitet.

**17.** Antennensystem, umfassend eine Einheit zum Transformieren des oder jedes Signals, das von mindestens einem Fühler (C_i wobei i = 1 bis N) geliefert wird, in den Frequenzbereich (UTF), ein Kanalfilter (FV_i), um in dem Frequenzbereich das von der Transformationseinheit (UTF) gelieferte Signal zu filtern, einen Summierer (SOM), um die jeweils von den Kanalfiltern (FV_i) gelieferten Signale zu summieren, und eine Transformationseinheit (UTT) im Zeitbereich des Signals, das von dem Summierer (SOM) geliefert wird, **dadurch gekennzeichnet, daß** es zwischen dem Summierer (SOM) und der Transformationseinheit im Zeitbereich (UTT) ein Filter (W) umfasst, dessen Übertragungsfunktion *(W(t,f))* gleich dem Verhältnis zweier linearer Funktionen (F) und (G) der Leistung *(P_y(t,f))* des Signals, das am Ausgang des Summierers (SOM) vorhanden ist, und der Leistung *(P_x(t,f))* des oder der Signale ist, die von der Trnasformationseinheit in dem Frequenzbereich (UTF) geliefert werden:

$$W(t,f) = \frac{F(\hat{P}_x(t,f),\ \hat{P}_y(t,f))}{G(P_x(t,f),\ P_y(t,f))}$$

**18.** System nach Anspruch 17, **dadurch gekennzeichnet, daß** die Übertragungsfunktion *(W(t,f))* des Filters (W) gleich dem Verhältnis der Leistung *(P_y(t,f))* des Signals am Ausgang des Summierers (SOM) und der Leistung *(P_x(t,f))* des oder der Signale ist, die von der Transformationseinheit in dem Frequenzbereich (UTF) geliefert werden:

$$W(t,f) = \frac{\hat{P}_{xy}(t, f)}{\hat{P}_x(t, f)}$$

**19.** Antennensystem nach Anspruch 17 oder 18, **dadurch gekennzeichnet, daß** es Bewertungseinheiten (ESTE, ESTS) umfaßt, um die Leistung $(P_y(t,f))$ des Signals, das am Ausgang des Summators (SOM) vorhanden ist, und der Leistung $(P_x(t,f))$ des oder der Signale, die von den Transformationseinheiten (UTF) geliefert werden, jeweils bewerten zu können.

**20.** Antennensystem nach Anspruch 19, **dadurch gekennzeichnet, daß** die Bewertungseinheit (ESTE) zur Bewertung der Leistung $(P_x(t,f))$ des oder der Signale, die von dem oder den Fühlern ($C_1$ bis $C_N$) an den Eingang der Antenne (ANT) geliefert wird, den Durchschnitt der Bewertung der Spektralleistungsdichten ($\Phi_{xixi}(t,f)$) der von dem oder den Fühlern ($C_1$ bis $C_N$) stammenden Signale berechnet:

$$\hat{P}_x(t,f) \sum_{i=1}^{N} \hat{\Phi}_{x_i x_i}(t,f)$$

**21.** Antennensystem nach Anspruch 19 oder 20, **dadurch gekennzeichnet, daß** die Bewertungseinheit (ESTS) zur Bewertung der Leistung $P_y(t,f)$ des Signals am Ausgang des Summierers (SOM) durch die Bewertung ($\Phi_{yy}(t,f)$ der Spektralleistungsdichte dieses Signals gegeben ist:

$$\hat{P}_y(t,f) = \hat{\Phi}_{yy}(t,f)$$

**22.** Antennensystem nach einem der Ansprüche 19 bis 21, **dadurch gekennzeichnet, daß** es Mittel umfasst, damit diese Bewertungen auf rekursive Art durch exponentielle Glättung durchgeführt werden.

FIG.1

FIG.2

FIG.3

FIG.4

FIG.5

FIG. 6

FIG.7

NIVEAU DE L'ECHO (PERTURBATION)

FIG. 8